# EUROPEAN PATENT APPLICATION

(11) **EP 2 816 379 A1**
(43) Date of publication of application: **24.12.2014**
(21) Application number: 13749054.6
(22) Date of filing: 18.02.2013
(51) Int. Cl.: G02B 1/11, B32B 7/02, B32B 9/00, G02B 1/10, G02C 7/00

(54) **OPTICAL COMPONENT, SPECTACLE LENS, AND MANUFACTURING METHODS THEREFOR**

(30) Priority: 17.02.2012 JP 2012033167
(71) Applicant: Nikon-Essilor Co., Ltd., Tokyo 130-0026 (JP)
(72) Inventor: TOMODA Masaoki, Tokyo 130-0026 (JP); MIYAMOTO So, Tokyo 130-0026 (JP)
(74) Representative: Viering, Jentschura & Partner Patent- und Rechtsanwälte
(86) International application number: PCT/JP2013/053876
(87) International publication number: WO 2013/122253

(57) **Abstract**

An optical component (1) is an optical component including: a plastic base (2); and a multilayer film disposed on at least a surface having a greater curvature, of a front surface (2a) of the plastic base (2) and a rear surface (2b) of the plastic base (2), wherein the multilayer film has a maximum reflectivity of 3% to 50% in a wavelength range of 380 nm to 780 nm.

## Description

### TECHNICAL FIELD

The present invention relates to an optical component, a spectacle lens, and a method of manufacturing the same.

Priority is claimed on Japanese Patent Application No. 2012-33167 filed on February 17, 2012, the contents of which are incorporated herein by reference.

### BACKGROUND

In recent years, for spectacle lenses, plastic lenses have been used in many cases due to advantages such as lightweight, excellent impact resistance, and ease of dyeing. In the plastic lens for use in a spectacle lens, an antireflection film is generally provided on both sides of the plastic lens for the purpose of preventing surface reflection. Generally, the antireflection film for a spectacle lens has a low reflection characteristic (wideband low-reflection characteristic) over the entire visible region of 400 nm to 700 nm.

In the case of an optical component such as a spectacle lens, an optical component which is provided with a plastic base and an antireflection film disposed on the base as disclosed in, for example, Patent Documents 1 to 3 is known.

### [Related Art Documents]

### [Patent Documents]

[Patent Document 1] Japanese Unexamined Patent Application, First Publication No. H11-30703
[Patent Document 2] Japanese Unexamined Patent Application, First Publication No. 2006-251760
[Patent Document 3] Japanese Unexamined Patent Application, First Publication No. 2007-127681

### SUMMARY OF INVENTION

### PROBLEMS TO BE SOLVED BY THE INVENTION

However, from recent studies, it is known that the low reflection characteristic over the entire visible region is not necessarily desirable for visibility and eye health. For example, by cutting the blue region (380 nm to 500 nm) of visible light, glare is reduced, and visibility and contrast are improved.

In addition, regarding eye health, since the blue region (380 nm to 500 nm) of visible light has a high intensity of energy, it is said to be a cause of impact to the retina and the like. The impact caused by blue light is referred to as "blue light hazard". Particularly, the most undesired region is about 435 nm to about 440 nm, and it is said that it is desirable to cut the light in this region.

Recently, in LED liquid crystal screens that have become the mainstream of displays and LED illumination, a lot of light with a wavelength of about 450 nm is emitted, and thus control of such light rays in the blue region has attracted attention. As means for cutting the blue region (380 nm to 500 nm) of visible light, a dyed lens such as sunglasses is known. However, in the dyed lens, the entire visible region is cut, and thus visibility may deteriorate due to a reduction in light intensity.

As an alternative, there is a method of cutting reflection in the blue region by using a multilayer film formed by alternately applying a high refractive index inorganic material and a low refractive index inorganic material in multilayers. However, in the case that the multilayer film has a reflectivity enough to obtain a sufficient effect, when wearing a lens provided with the multilayer film as a spectacle lens, the user feels annoyed due to reflection light from a lens front surface.

For example, in a negative diopter spectacle lens, the curvature of a front surface onto which light is incident is smaller than the curvature of a rear surface which is the face side surface at the time of wearing and from which the light exits. Therefore, since incident light from the rearward at the time of wearing is reflected by the front surface and the reflected light focuses near the eyeball, the user feels annoyed. In addition, since a reflection image of an interior lamp or the like on the front surface stands out greatly, other people may have a feeling of strangeness when looking at the appearance.

Thus, when cutting a specific wavelength, it is necessary to select a suitable surface to which a multilayer film is added and a reflectivity.

An object of an aspect of the present invention is to provide an optical component and a spectacle lens, each of which has a filter function such as an antiglare effect, is effective for a reduction in feeling of fatigue and prevention of eye trouble, and is excellent in visibility, and a method of manufacturing the optical component and the spectacle lens.

### MEANS FOR SOLVING THE PROBLEM

An optical component according to an aspect of the present invention includes: a plastic base; and a multilayer film disposed on at least a surface having a greater curvature, of a front surface of the plastic base and a rear surface of the plastic base, wherein the multilayer film has a maximum reflectivity of 3% to 50% in a wavelength range of 380 nm to 780 nm.

In addition, a method of manufacturing an optical component according to an aspect of the present invention is a method of manufacturing the optical component that is provided with a plastic base and a multilayer film disposed on at least a surface having a greater curvature, of a front surface of the plastic base and a rear surface of the plastic base, the method including: a step of heating the plastic base; and a step of forming the multilayer film on the plastic base after adjusting a temperature of the plastic base to a predetermined temperature by the heating, wherein the step of forming the multilayer film has a process of forming a high refractive index layer having a multilayer structure by alternately applying a high refractive index material and a low refractive index material in multilayers and has a process of forming, on the high refractive index layer, a low refractive index layer formed by a low refractive index material having a lower refractive index than a refractive index of the high refractive index layer, and wherein the maximum reflectivity of the multilayer film in a wavelength range of 380 nm to 780 nm is 3% to 50%.

In addition, a spectacle lens according to an aspect of the present invention includes: a plastic base having a front surface and a rear surface; a first multilayer film provided on the front surface, the first multilayer film having an average reflectivity of 3% or less in a wavelength range of 380 nm to 780 nm; and a second multilayer film provided on the rear surface, the second multilayer film having an average reflectivity of 2% to 13% in a 30-nm-width range including a first wavelength of a local maximum reflectivity, the range being in a wavelength range of 415 nm to 780 nm.

In addition, a spectacle lens according to an aspect of the present invention includes: a plastic base having a front surface and a rear surface; a first multilayer film provided on the front surface, the first multilayer film having an average reflectivity of less than 3% in a wavelength range of 380 nm to 780 nm; and a second multilayer film provided on the rear surface, the second multilayer film having an average reflectivity of 3% to 30% in a 30-nm-width range including a first wavelength at which the reflectivity is maximized, the range being in a wavelength range of 380 nm to 500 nm.

In addition, a method of manufacturing a spectacle lens according to an aspect of the present invention includes: a step of heating a plastic base; and a step of forming a multilayer film on the heated plastic base, the step including: a process of forming a high refractive index layer of a multilayer structure having a layer of a high refractive index material and a layer of a low refractive index material; and a process of forming a low refractive index layer having a lower refractive index relative to the high refractive index layer, and wherein a first multilayer film provided on a front surface has an average reflectivity of less than 3% in a wavelength range of 380 nm to 780 nm, and a second multilayer film provided on a rear surface has an average reflectivity of 3% to 30% in a 30-nm-width range including a first wavelength at which a reflectivity is maximized, the range being in a wavelength range of 380 nm to 500 nm.

### ADVANTAGE OF THE INVENTION

According to an optical component of an aspect of the present invention, a filter function such as a sufficient antiglare effect can be obtained while maintaining excellent visibility.

In addition, according to a method of manufacturing an optical component of an aspect of the present invention, an optical component with reduced glare, with which it is easy to see, and which has optical characteristics effective for prevention of fatigue and eye trouble, can be provided.

### BRIEF DESCRIPTION OF THE DRAWINGS

FIG. 1 is a schematic diagram showing an example of an optical component according to a first embodiment.
FIG. 2 is a schematic diagram showing an example of an optical component according to a second embodiment.
FIG. 3 is a schematic diagram showing an example of a deposition apparatus according to the first embodiment.
FIG. 4 is a schematic diagram showing an example of a film formation apparatus according to the first embodiment.
FIG. 5A is a graph showing a spectral characteristic of a multilayer film according to a lens rear surface of Example 1 and a lens front surface of Comparative Example 1.
FIG. 5B is data showing the spectral characteristic of the multilayer film according to the lens rear surface of Example 1 and the lens front surface of Comparative Example 1.
FIG. 6A is a graph showing a spectral characteristic of a multilayer film according to a lens front surface of Example 1 and a lens rear surface of Comparative Example 1.
FIG. 6B is data showing the spectral characteristic of the multilayer film according to the lens front surface of Example 1 and the lens rear surface of Comparative Example 1.
FIG. 7A is a graph showing a spectral characteristic of a multilayer film according to a lens rear surface of Example 2 and a lens front surface of Comparative Example 2.
FIG. 7B is data showing the spectral characteristic of the multilayer film according to the lens rear surface of Example 2 and the lens front surface of Comparative Example 2.
FIG. 8A is a graph showing a spectral characteristic of a multilayer film according to a lens front surface of Example 2 and a lens rear surface of Comparative Example 2.
FIG. 8B is data showing the spectral characteristic of the multilayer film according to the lens front surface of Example 2 and the lens rear surface of Comparative Example 2.
FIG. 9A is a graph showing a spectral characteristic of a multilayer film according to a lens rear surface of Example 3 and a lens front surface of Comparative Example 3.
FIG. 9B is data showing the spectral characteristic of the multilayer film according to the lens rear surface of Example 3 and the lens front surface of Comparative Example 3.
FIG. 10A is a graph showing a spectral characteristic of a multilayer film according to a lens front surface of Example 3 and a lens rear surface of Comparative Example 3.
FIG. 10B is data showing the spectral characteristic of the multilayer film according to the lens front surface of Example 3 and the lens rear surface of Comparative Example 3.
FIG. 11A is a graph showing a transmission characteristic of a lens of Example 1.
FIG. 11B is data showing the transmission characteristic of the lens of Example 1.
FIG. 12A is a graph showing a transmission characteristic of a lens of Example 2.
FIG. 12B is data showing the transmission characteristic of the lens of Example 2.
FIG. 13A is a graph showing a transmission characteristic of a lens of Example 3.
FIG. 13B is data showing the transmission characteristic of the lens of Example 3.
FIG. 14A is a graph showing a spectral characteristic of a multilayer film according to a lens rear surface of Example 4 and a lens front surface of Comparative Example 5.
FIG. 14B is data showing the spectral characteristic of the multilayer film according to the lens rear surface of Example 4 and the lens front surface of Comparative Example 5.
FIG. 15A is a graph showing a spectral characteristic of a multilayer film according to a lens front surface of Example 4 and a lens rear surface of Comparative Example 5.
FIG. 15B is data showing the spectral characteristic of the multilayer film according to the lens front surface of Example 4 and the lens rear surface of Comparative Example 5.
FIG. 16A is a graph showing a transmission characteristic of a lens of Example 4.
FIG. 16B is data showing the transmission characteristic of the lens of Example 4.
FIG. 17A is a graph showing a transmission characteristic of a lens of Example 5.
FIG. 17B is data showing the transmission characteristic of the lens of Example 5.
FIG. 18 shows results of Comparative wearing evaluation 1 according to Test 2.
FIG. 19 shows results of Comparative wearing evaluation 2 according to Test 2.

### DESCRIPTION OF EMBODIMENTS

Hereinafter, embodiments of the present invention will be described in detail.

The embodiments are described in detail to achieve a better understanding of the points of the invention, but the present invention is not limited thereto unless otherwise stated.

### [Optical Component]

### (1) First Embodiment

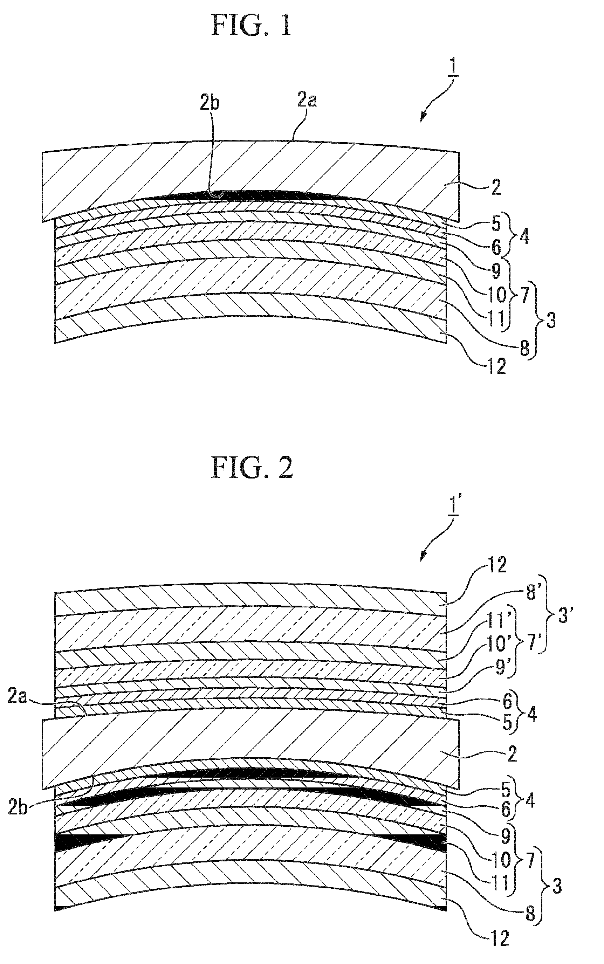

FIG. 1 is a sectional side view schematically showing a first embodiment of an optical component of the present invention. The reference numeral 1 in FIG. 1 represents an optical component for a spectacle lens.

The optical component 1 is provided with a plastic base 2 and an inorganic multilayer film 3 disposed on one surface of the plastic base 2 having a greater curvature than the other surface. In the present embodiment, of a front surface 2a of the plastic base and a rear surface 2b of the plastic base, the rear surface 2b is the surface having a greater curvature.

In addition, a functional thin film 4 is disposed between the rear surface 2b of the plastic base 2 and the inorganic multilayer film 3. In the present embodiment, the functional thin film 4 is formed by a primer layer 5 and a hard coating layer 6.

In the present embodiment, an arbitrary film which corresponds to the inorganic multilayer film 3 and the functional thin film 4 is formed on the front surface 2a (surface having a smaller curvature) of the plastic base 2; however, an illustration and description of the film are omitted.

The plastic base 2 is made of, for example, transparent plastic such as an acryl-based resin, a thiourethane-based resin, a methacryl-based resin, an allyl-based resin, an episulfide-based resin, a polycarbonate-based resin, a polyurethane-based resin, a polyester-based resin, a polystyrene-based resin, an episulfide resin, a polyethersulfone resin, a poly-4-methylpentene-1 resin, a diethylene glycol bis allyl carbonate resin (CR-39), a polyvinyl chloride resin, a halogen-containing copolymer, and a sulfur-containing copolymer.

In addition, in the present embodiment, for example, one of 1.50, 1.60, 1.67, and 1.74 is selected and used as a refractive index (nd) of the plastic base 2. When the refractive index of the plastic base 2 is set to 1.6 or greater, an allyl carbonate-based resin, an acrylate-based resin, a methacrylate-based resin, a thiourethane-based resin and the like can be used for the plastic base 2.

The diopter of the plastic base 2 can be a negative value. The curvature of the rear surface in such a base is greater than the curvature of the front surface.

In addition, the plastic base 2 may not be transparent, or may be colored if it is translucent. The transmissivity of the colored plastic base 2 can be 5% to 85%.

The functional thin film 4 is disposed between the plastic base 2 and the inorganic multilayer film 3 as described above, and is formed of the primer layer 5 which is disposed in contact with the plastic base 2 and the hard coating layer 6 which is disposed in contact with the primer layer 5 and in contact with the inorganic multilayer film 3.

The primer layer 5 is used to improve the adhesion between the plastic base 2 and the hard coating layer 6 and functions as an adhesion layer. In addition, the primer layer 5 is also used to absorb the impact on the optical component 1 and functions as an impact absorption layer.

The primer layer 5 contains a polyurethane-based resin as a main component, and in the present embodiment, the primer layer 5 is a polyurethane-based resin containing, for example, particulates of an inorganic material.

Note that, the primer layer 5 may include at least one type of an acryl-based resin, a methacryl-based resin, and an organosilicon-based resin. The thickness (actual thickness) of the primer layer 5 can be about 0.5 µm to about 1.0 µm.

The primer layer 5 can be formed with a predetermined thickness on the plastic base 2 by dipping the plastic base 2 in a liquid for forming the primer layer 5 and then lifting and drying the plastic base 2.

As the liquid for forming the primer layer 5, for example, a liquid in which a resin to be the primer layer 5 and an inorganic oxide particulate sol are dispersed or dissolved in water or an alcohol-based solvent and mixed therewith can be used.

The hard coating layer 6 has a function of protecting the plastic base 2 and suppressing impact to the plastic base 2 and functions as an abrasion-resistant film.

The hard coating layer 6 is formed of, for example, an organosiloxane-based hard coating layer. The organosiloxane-based hard coating layer is a layer in which particulates of inorganic oxide are dispersed in an organosiloxane-based resin. As the inorganic oxide, for example, rutile-type titanium oxide and oxides of silicon, tin, zirconium, and antimony are used.

In addition, the hard coating layer 6 may be, for example, a colloidal silica-containing organosilicon-based resin as disclosed in Japanese Examined Patent Application, Second Publication No. H4-55615. The thickness (actual thickness) of the hard coating layer 6 can be about 2 µm to about 4 µm.

The hard coating layer 6 can be formed with a predetermined thickness on the primer layer 5 on the plastic base 2 by dipping the plastic base 2 having the primer layer 5 formed thereon in a liquid for forming the hard coating layer 6 and then lifting and drying the plastic base 2.

As the liquid for forming the hard coating layer 6, for example, a liquid in which a resin to be the hard coating layer 6 and an inorganic oxide particulate sol are dispersed or dissolved in water or an alcohol-based solvent and mixed therewith can be used.

When the refractive index of the functional thin film 4 including the primer layer 5 and the hard coating layer 6 is substantially the same as the refractive index of the plastic base 2, it is possible to suppress a reduction in transmissivity and the occurrence of interference fringes which are caused by the reflection at an interface between the functional thin film 4 and the plastic base 2.

Accordingly, the refractive index of the functional thin film 4 is adjusted in accordance with the refractive index of the plastic base 2. The adjustment of the refractive index of the functional thin film 4 (primer layer 5 and hard coating layer 6) can be performed by selecting the type (physical properties) of resin which is a main component of the functional thin film 4, or by selecting the type (physical properties) of particulates added to the resin which is a main component, or the like.

In the present embodiment, the functional thin film 4 is formed to include the primer layer 5 and the hard coating layer 6. However, for example, one or both of the primer layer 5 and the hard coating layer 6 may be omitted.

In addition, as a constituent film of the functional thin film 4, for example, a dielectric film made of indium tin oxide (ITO) or the like, or a metallic film may be disposed in addition to the primer layer 5 and the hard coating layer 6.

In addition, in the present embodiment, a dielectric film or a metallic film having a thickness of 20 nm or less may be disposed between a high refractive index inorganic material and a low refractive index inorganic material constituting the inorganic multilayer film. The thickness of the dielectric film or the metallic film may be 10 nm or less.

The inorganic multilayer film 3 has a double-layer configuration, which has a high refractive index layer 7 having a multilayer structure in which a high refractive index inorganic material and a low refractive index inorganic material are alternately applied in multilayers on the plastic base 2 and has a low refractive index layer 8 made of a low refractive index inorganic material having a lower refractive index than that of the high refractive index layer 7 on the high refractive index layer 7.

In the present embodiment, the inorganic multilayer film 3 is designed to have a maximum reflectivity of 3% to 50% in a wavelength range of 380 nm to 780 nm.

When the maximum reflectivity is in the above range, a filter function such as a sufficient antiglare effect can be obtained and excellent visibility can be maintained in use as a spectacle lens.

When the maximum reflectivity in this wavelength region is set to 3% or less, a person wearing such glasses may not obtain a filter function such as a sufficient antiglare effect, a fatigue prevention effect, and an eye trouble prevention effect.

On the other hand, when the maximum reflectivity in this wavelength region is set to over 50%, a transmission light intensity may be reduced, and visibility may deteriorate.

The maximum reflectivity can be 3% to 35% and is preferably 3% to 15%.

In addition, in the present embodiment, an inorganic multilayer film is used as a multilayer film. However, an organic multilayer film may be used as long as the advantageous effect of the present invention is not impaired.

Moreover, an antireflection film having an average reflectivity of 5.0% or less in a wavelength region of 380 nm to 780 nm can be disposed on the front surface 2a (surface having a smaller curvature). The average reflectivity of the antireflection film is preferably 3.5% or less. From the viewpoint of obtaining better visibility, the average reflectivity of the antireflection film is preferably 2.0% or less.

By disposing such an antireflection film, a spectacle lens which has a more effective filter function such as an antiglare effect and better visibility can be obtained.

In the present embodiment, the high refractive index layer 7 is formed of a first layer 9 made of a high refractive index inorganic material which is provided close to the plastic base 2, a second layer 10 made of a low refractive index inorganic material which is provided on the first layer 9, and a third layer 11 made of a high refractive index inorganic material which is provided on the second layer 10.

The first layer 9 is provided in contact with the hard coating layer 6 and is made of zirconium dioxide (ZrO₂) having a refractive index of 2.0. Other than ZrO₂, for example, titanium dioxide (TiO₂) and tantalum dioxide (Ta₂O₅) can be used as the high refractive index inorganic material constituting the first layer 9.

Furthermore, the first layer 9 can also be formed of oxide of an alloy including several elements selected from zirconium, titanium, and tantalum. In addition to these, for example, aluminum oxide (Al₂O₃), yttrium dioxide (Y₂O₃), hafnium dioxide (HfO₂), and niobium dioxide (Nb₂O₅) can also be used.

Here, in this manner, when the first layer 9 is formed of a high refractive index inorganic material (ZrO₂), the adhesion between the first layer 9 and the hard coating layer 6 can be improved. That is, this is because the adhesion (adhesion power) between the layer (ZrO₂) made of a high refractive index inorganic material and the hard coating layer 6 is greater than the adhesion (adhesion power) between the layer (SiO₂) made of a low refractive index inorganic material and the hard coating layer 6.

In addition, even when the functional thin film 4 (primer layer 5 and hard coating layer 6) is omitted, the adhesion (adhesion power) between the high refractive index layer (ZrO₂) and the plastic base 2 is greater than the adhesion (adhesion power) between the low refractive index layer (SiO₂) and the plastic base 2, and thus using a high refractive index inorganic material is further advantageous regarding adhesion.

The second layer 10 is provided in contact with the first layer 9 and is made of silicon dioxide (SiO₂) having a refractive index of 1.47. Other than SiO₂, for example, MgF₂ having a refractive index of 1.36 can be used as the low refractive index inorganic material constituting the second layer 10.

The third layer 11 is provided in contact with the second layer 10 and is made of zirconium dioxide (ZrO₂) as in the first layer 9. As in the first layer 9, the third layer 11 can be formed by a high refractive index inorganic material other than ZrO₂.

In addition, the high refractive index layer 7 can be formed not to have a three-layer structure of the first layer 9, the second layer 10, and the third layer 11 as described above, but to be configured in two layers or in four or more layers if the above-described reflectivity condition is satisfied.

The low refractive index layer 8 is provided in contact with the third layer 11 and is made of silicon dioxide (SiO₂) as in the second layer 10.

In addition, in the present embodiment, on the inorganic multilayer film 3, that is, on the outermost layer (low refractive index layer 8) of the inorganic multilayer film 3 which is the farthest from the plastic base 2, a water-and-oil repellent film 12 including a fluorine-substituted alkyl group-containing organosilicon compound is provided.

The water-and-oil repellent film 12 contains the fluorine-substituted alkyl group-containing organosilicon compound as a main component, and has liquid repellency (water repellency and oil repellency). That is, the water-and-oil repellent film 12 reduces the surface energy of the optical component to exhibit a function of preventing water marks and preventing contamination, and improves the sliding property of the surface of the optical component. As a result, abrasion resistance can be improved.

As the fluorine-substituted alkyl group-containing organosilicon compound, one of the following general formulas (1) to (6) is selected: 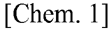 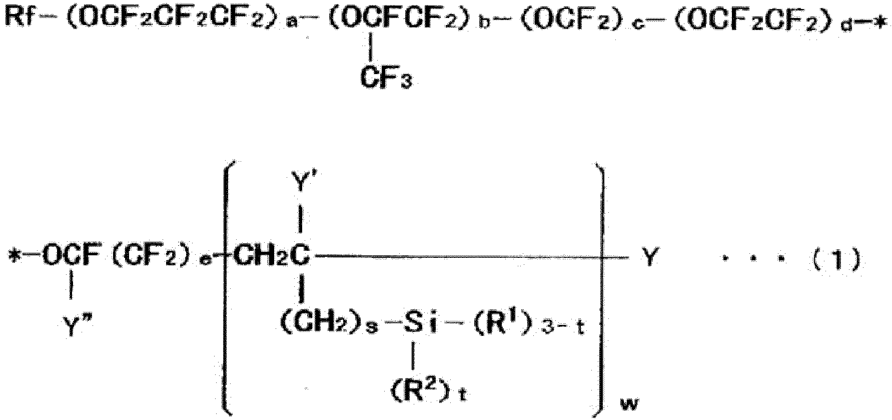 (in the formula (1), Rf represents a straight or branched perfluoroalkyl group with 1 to 16 carbon atoms, Y represents iodine or hydrogen, Y' represents hydrogen or a lower alkyl group with 1 to 5 carbon atoms, Y" represents fluorine or a trifluoromethyl group, R¹ represents a hydrolyzable group, R² represents hydrogen or an inert monovalent organic group, a, b, c, and d each represents an integer of 0 to 200, e represents 0 or 1, s and t each represents an integer of 0 to 2, and w represents an integer of 1 to 10); 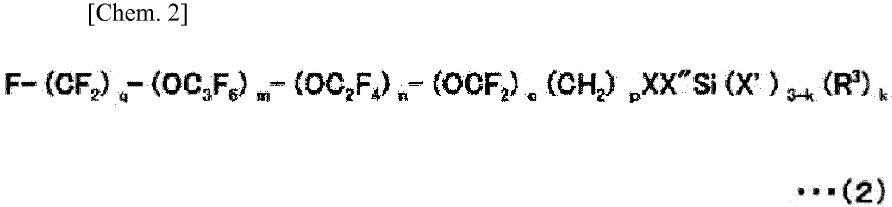 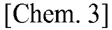 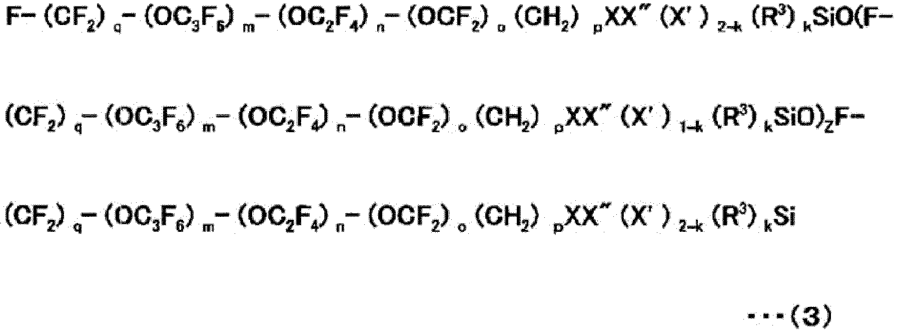 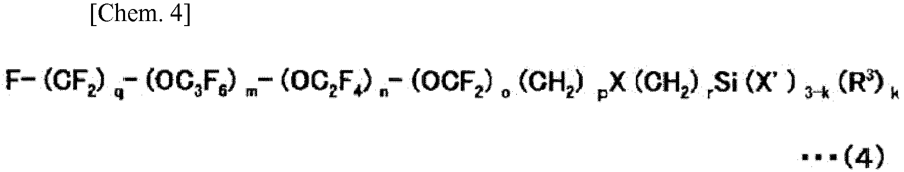 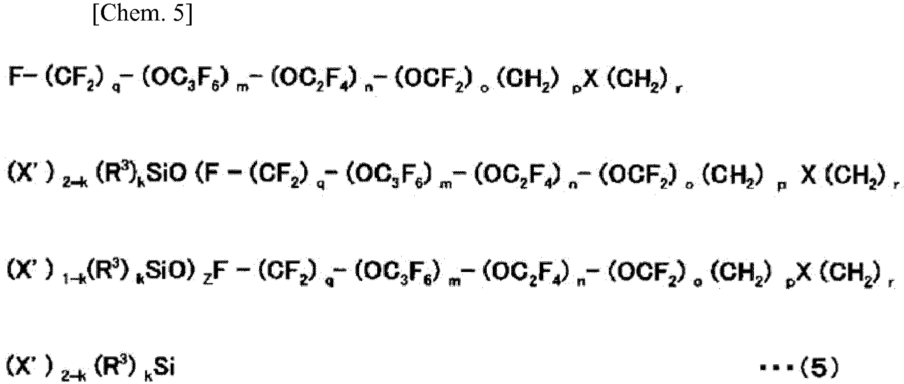 (in the formulas (2) to (5), X represents oxygen or a divalent organic group, X' represents a hydrolyzable group, X" represents a divalent organosilicon group, R³ represents a straight or branched alkylene group with 1 to 22 carbon atoms, q represents an integer of 1 to 3, m, n, and o each represents an integer of 0 to 200, p represents 1 or 2, r represents an integer of 2 to 20, k represents an integer of 0 to 2, and z represents an integer of 0 to 10 when k is 0 or 1); and 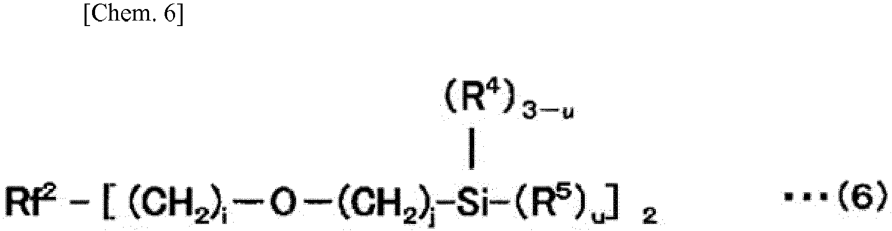 (in the formula (6), Rf² represents a divalent straight perfluoropolyether group, R⁴ represents a phenyl group or an alkyl group with 1 to 4 carbon atoms, R⁵ represents a hydrolyzable group, i represents an integer of 0 to 2, j represents an integer of 1 to 5, and u represents 2 or 3).

Here, in order to give excellent durability to the water-and-oil repellent film 12, the fluorine-substituted alkyl group-containing organosilicon compound selected from the general formulas (1) to (5) and the fluorine-substituted alkyl group-containing organosilicon compound selected from the general formula (6) can be combined and used.

As the fluorine-substituted alkyl group-containing organosilicon compound shown in the general formulas (1) to (5), Optool DSX and Optool AES4 manufactured by Daikin Industries, Ltd., and the like can be used. In addition, as the fluorine-substituted alkyl group-containing organosilicon compound shown in the general formula (6), KY-130 and KY-164 manufactured by Shin-Etsu Chemical Co., Ltd., and the like can be used.

### (2) Second Embodiment

FIG. 2 is a sectional side view schematically showing a second embodiment of an optical component of the present invention. The reference numeral 1' in FIG. 2 represents an optical component for a spectacle lens. In FIG. 2, the same constituent elements as in the optical component 1 shown in FIG. 1 will be denoted by the same reference numerals, and descriptions thereof will be omitted here.

The optical component 1' is provided with, in addition to the structure of the optical component 1 of the first embodiment, an inorganic multilayer film 3' disposed on a front surface 2a (surface having a smaller curvature) of a plastic base 2. In the present embodiment, of a front surface 2a of the plastic base 2 and a rear surface 2b of the plastic base 2, the rear surface 2b is the surface having a greater curvature.

In addition, a functional thin film 4 is disposed between the front surface 2a of the plastic base 2 and the inorganic multilayer film 3'. The functional thin film 4 is formed of a primer layer 5 and a hard coating layer 6 in the present embodiment.

The inorganic multilayer film 3' has a double-layer configuration which has a high refractive index layer 7' having a multilayer structure in which a high refractive index inorganic material and a low refractive index inorganic material are alternately applied in multilayers on the plastic base 2, and has a low refractive index layer 8' made of a low refractive index inorganic material having a lower refractive index than that of the high refractive index layer 7' on the high refractive index layer 7'.

In the present embodiment, the high refractive index layer 7' is formed of a first layer 9' made of a high refractive index inorganic material which is provided close to the plastic base 2, a second layer 10' made of a low refractive index inorganic material which is provided on the first layer 9', and a third layer 11' made of a high refractive index inorganic material which is provided on the second layer 10'.

In the present embodiment, examples of the inorganic materials which are used in the first layer 9', the second layer 10', and the third layer 11' include the same materials as the inorganic materials which are used in the first layer 9, the second layer 10, and the third layer 11 in the first embodiment.

Like the high refractive index layer 7 in the first embodiment, the high refractive index layer 7' can be formed not to have a three-layer structure, but to be configured in two layers or in four or more layers.

In the present embodiment, the inorganic multilayer film 3' disposed on the surface having a smaller curvature (front surface 2a) is designed to have a maximum reflectivity in a wavelength range of 380 nm to 780 nm which is smaller than a maximum reflectivity of the inorganic multilayer film 3 disposed on the surface having a greater curvature (rear surface 2b).

That is, the maximum reflectivity of the inorganic multilayer film 3 disposed on the surface having a greater curvature (rear surface 2b) is greater than the maximum reflectivity of the inorganic multilayer film 3' disposed on the surface having a smaller curvature (front surface 2a).

In addition, the inorganic multilayer film 3 disposed on the rear surface 2b of the plastic base 2 is designed to have a maximum reflectivity of 4% to 35%, and is preferably designed to have a maximum reflectivity of 4% to 15%.

The inorganic multilayer film 3' disposed on the front surface 2a of the plastic base 2 is designed to have a maximum reflectivity of 3% to 30%, and is preferably designed to have a maximum reflectivity of 3% to 10%.

In an example, the multilayer film 3' (first multilayer film) provided on the front surface 2a can have an average reflectivity of 3% or less in a wavelength range of 380 nm to 780 nm, and the multilayer film 3 (second multilayer film) provided on the rear surface 2b can have an average reflectivity of 2% to 13% in a 30-nm-width range including a wavelength (first wavelength) of a local maximum reflectivity in a wavelength range of 415 nm to 780 nm (or 750 nm).

In an example, the multilayer film 3' (first multilayer film) provided on the front surface 2a can have an average reflectivity of 3% or less in a wavelength range of 380 nm to 780 nm, and the multilayer film 3 (second multilayer film) provided on the rear surface 2b can have an average reflectivity of 3% to 30% in a 30-nm-width range including a wavelength (first wavelength) at which the reflectivity is maximized in a wavelength range of 380 nm to 500 nm.

In addition, the multilayer film 3' (first multilayer film) can have an average reflectivity of less than 1.5% in a wavelength range of 380 nm to 780 nm and an average reflectivity of less than 3% in a wavelength range of 380 nm to 500 nm.

In addition, the difference between the maximum reflectivity of the inorganic multilayer film 3 disposed on the surface having a greater curvature (rear surface 2b) and the maximum reflectivity of the inorganic multilayer film 3' disposed on the surface having a smaller curvature (front surface 2a) can be 2% to 49%.

The maximum reflectivity difference is preferably 2% to 10% when the curvature radius of the front surface is less than 400 mm, the maximum reflectivity difference is preferably 2% to 15% when the curvature radius of the front surface is 400 mm or more and less than 1500 mm, and the maximum reflectivity difference is preferably 5% to 15% when the curvature radius of the front surface is 1500 mm or more.

In an example, the difference between the reflectivity of the multilayer film (first multilayer film) 3' and the reflectivity of the multilayer film (second multilayer film) 3 at a wavelength (first wavelength) of a local maximum reflectivity in a wavelength range of 415 nm to 780 nm (or 750 nm) can be 1% to 10%.

In an example, the difference between the reflectivity of the multilayer film (first multilayer film) 3' and the reflectivity of the multilayer film (second multilayer film) 3 at a wavelength (first wavelength) where the reflectivity is maximized in a wavelength range of 380 nm to 500 nm can be 3% to 41%.

In the present embodiment, the functional thin film 4 is formed to include the primer layer 5 and the hard coating layer 6. However, as in the first embodiment, for example, one or both of the primer layer 5 and the hard coating layer 6 may be omitted.

In addition, as a constituent film of the functional thin film 4, for example, a dielectric film made of indium tin oxide (ITO) or the like, or a metallic film may be disposed in addition to the primer layer 5 and the hard coating layer 6.

In addition, in the present embodiment, a dielectric film or a metallic film having a thickness of 20 nm or less may be disposed between a high refractive index inorganic material and a low refractive index inorganic material constituting the inorganic multilayer film. The thickness of the dielectric film or the metallic film may be 10 nm or less.

In addition, in the present embodiment, an inorganic multilayer film is used as a multilayer film. However, an organic multilayer film may be used as long as the advantageous effect of the present invention is not impaired.

### [Manufacturing Method of Optical Component]

Next, an embodiment of a method of manufacturing the optical component according to the present invention will be described based on a method of manufacturing the optical component 1.

The method of manufacturing the optical component in the present embodiment includes a step of forming the functional thin film 4 (primer layer 5 and hard coating layer 6) on the plastic base 2 by a method which is the same as in the conventional case, a step of heating the plastic base 2, a step of forming the inorganic multilayer film 3 on the plastic base 2 after adjusting the temperature of the plastic base 2 to a predetermined temperature (for example, 70 degrees Celsius) by the heating, and a step of forming the water-and-oil repellent film 12 on the inorganic multilayer film 3.

The step of forming the inorganic multilayer film 3 has a process of forming the high refractive index layer 7 having a multilayer structure by alternately applying a high refractive index inorganic material and a low refractive index inorganic material in multilayers, and a process of forming, on the high refractive index layer 7, the low refractive index layer 8 made of a low refractive index inorganic material. A vacuum deposition method is used to form the layers.

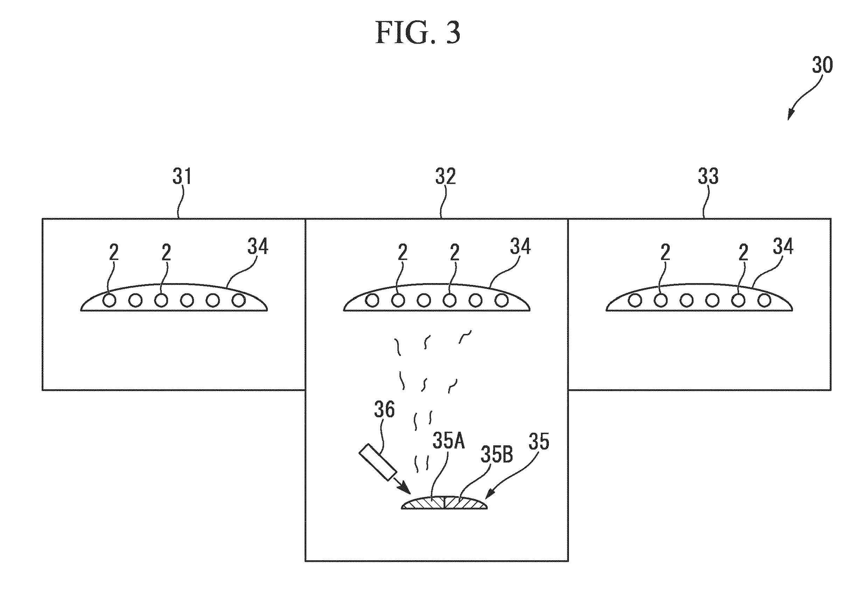

FIG. 3 is a diagram showing an example of a deposition apparatus 30 for forming the layers of the inorganic multilayer film 3. As shown in FIG. 3, the deposition apparatus 30 is provided with a first film formation chamber 31, a second film formation chamber 32, and a third film formation chamber 33. The first film formation chamber 31, the second film formation chamber 32, and the third film formation chamber 33 are configured such that the inside of each is decompressed substantially to a vacuum and is held in that state.

In addition, in the deposition apparatus 30, the internal temperature of each of the first film formation chamber 31, the second film formation chamber 32, and the third film formation chamber 33 is adjustable using a temperature control unit (not shown in the drawing).

The deposition apparatus 30 is provided with a holding member 34 in the internal space of each of the first film formation chamber 31, the second film formation chamber 32, and the third film formation chamber 33. The holding member 34 has a curved upper surface (holding surface) and is configured to be rotatable. The holding member 34 is configured to hold a plurality of plastic bases 2 on the upper surface thereof.

A deposition source 35 of the deposition apparatus 30 is disposed in a space inside of the second film formation chamber 32. The deposition source 35 includes a first deposition source 35A and a second deposition source 35B. In addition, a light source device 36 which is capable of irradiating the deposition source 35 with beams is disposed in the second film formation chamber 32. The light source device 36 can irradiate the deposition source 35 with electrons and sputter constituent particles of the deposition source 35.

The deposition source 35 is irradiated with the electrons emitted from the light source device 36, and thereby a material (gas) for forming the inorganic multilayer film 3 is ejected from the deposition source 35.

For example, the light source device 36 irradiates the first deposition source 35A with beams, and thereby ZrO₂ vapor is ejected from the first deposition source 35A and supplied to be deposited onto the plastic base 2 which is held on the holding member 34. Accordingly, the first layer 9 and the third layer 11 in the high refractive index layer 7 of the inorganic multilayer film 3 can be formed.

Similarly, by irradiating the second deposition source 35B with beams, SiO₂ vapor is ejected from the second deposition source 35B and supplied to be deposited onto the plastic base 2 which is held on the holding member 34. Accordingly, the second layer 10 in the high refractive index layer 7 of the inorganic multilayer film 3 and the low refractive index layer 8 can be formed.

That is, by alternately performing the irradiation of the first deposition source 35A with beams and the irradiation of the second deposition source 35B with beams, a layer made of a high refractive index inorganic material and a layer made of a low refractive index inorganic material can be alternately formed and applied on the plastic base 2 which is held on the holding member 34.

In the present invention, the inorganic multilayer film 3 is designed to have a maximum reflectivity of 3% to 50% in a wavelength range of 380 nm to 780 nm. Furthermore, an antireflection film is disposed on the surface having a smaller curvature (front surface 2a), and the antireflection film is designed to have a reflectivity of 5.0% or less in a wavelength region of 380 nm to 780 nm.

A deposition source made of zirconium oxide (ZrO) may be used as the first deposition source 35A and the first deposition source 35A may be irradiated with beams while introducing oxygen to the internal space of the second chamber 32 to form a high refractive index inorganic material layer made of zirconium dioxide (ZrO₂).

In addition, in the method of manufacturing the optical component according to the present embodiment, the step of forming the inorganic multilayer film 3 may include a step of performing ion beam assisted film formation to form at least one layer of the layers constituting the inorganic multilayer film 3. The method of manufacturing the optical component according to the present embodiment includes such a step, and thereby a dielectric film is disposed between the high refractive index inorganic material and the low refractive index inorganic material constituting the inorganic multilayer film.

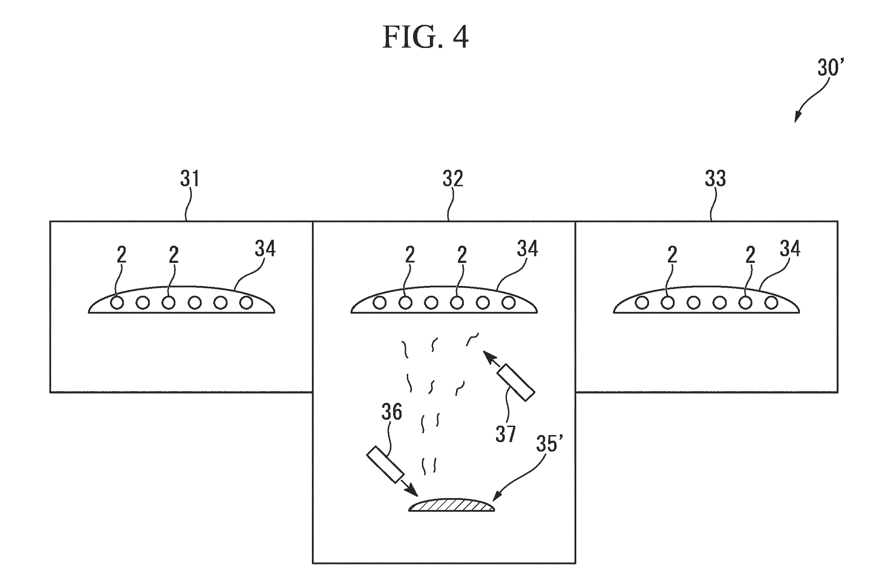

FIG. 4 is a diagram showing an example of a film formation apparatus 30' used to apply ion beam assisting. The film formation apparatus 30' is provided with an ion gun 37 in the second film formation chamber of the film formation apparatus 30 shown in FIG. 3. In FIG. 4, the same constituent elements as in the deposition apparatus 30 shown in FIG. 3 will be denoted by the same reference numerals, and descriptions thereof will be omitted here.

In the present embodiment, when a dielectric film of ITO or the like is disposed between the high refractive index layer 7 and the low refractive index layer 8 constituting the inorganic multilayer film 3, ion beam assisted film formation is performed.

Note that, at least one layer of the layers constituting the inorganic multilayer film 3 may be formed by ion beam assisted film formation in the second film formation chamber 32, and the layer formed by ion beam assisted film formation is not limited to a dielectric film.

In the present embodiment, the second film formation chamber 32 of the film formation apparatus 30' is configured by a holding member 34 to hold a base having a high refractive index layer 7 formed on the plastic base 2, a deposition source 35', an ion gun 37 disposed away from the deposition source 35', and a light source device 36, as main constituents.

In addition, the inside of the film formation apparatus 30' can be decompressed substantially to vacuum, and the area surrounding the plastic base 2 can be held in a vacuum atmosphere. Moreover, an atmosphere gas supply source such as a gas cylinder is connected to the film formation apparatus 30', and the inside of the vacuum vessel can be made to be in a low-pressure state such as vacuum and in an inert gas atmosphere of an oxygen gas, an argon gas, or the like or an inert gas atmosphere including oxygen.

The deposition source 35' includes, for example, ITO. The light source device 36 irradiates the deposition source 35' with beams, and thereby gasified ITO is ejected from the deposition source 35' and is supplied to the plastic base 2 which is held on the holding member 34. Thus, a dielectric film made of ITO can be formed on the high refractive index layer 7.

An ion gun device is provided with the ion gun 37 disposed inside of the second film formation chamber 32, a gas introduction unit (not shown in the drawing) used to introduce a gas to be ionized, and an extraction electrode (not shown in the drawing) provided at the front of the ion gun 37.

The ion gun device ionizes part of gas atoms or gas molecules, controls the ionized particles by an electric field which is produced by the extraction electrode to generate ion beams, and irradiates the sample with the ion beams.

The light source device 36 has a configuration similar to that of the ion gun 37, and is capable of irradiating the deposition source 35' with electrons to sputter constituent particles of the deposition source 35'.

Note that, since it is important that the film formation apparatus 30' is capable of sputtering the constituent particles of the deposition source 35', the film formation apparatus 30' may be configured to be capable of applying a voltage to the deposition source 35' using a high-frequency coil or the like to sputter the constituent particles of the deposition source 35', and the light source device 36 may be omitted.

Next, a case in which a dielectric film of ITO is formed onto a high refractive index layer 7 on the plastic base 2 using the film formation apparatus 30' having the above configuration will be described. When a dielectric film of ITO is formed, a deposition source 35' of ITO is used, and a configuration is used in which an upper surface of the holding member 34 can be irradiated with ions emitted from the ion gun 37. Next, the inside of the film formation chamber 32 which stores the plastic base 2 is evacuated to be in a decompressed atmosphere. Then, the ion gun 37 and the light source device 36 are operated.

When the light source device 36 irradiates the deposition source 35' with electrons, the constituent particles of the deposition source 35' are sputtered, and fly to arrive on the high refractive index layer 7. Then, the constituent particles sputtered from the deposition source 35' are deposited on the high refractive index layer 7, and at the same time, the ion gun 37 irradiates the high refractive index layer 7 with argon ions.

In the present embodiment, the ion beam assisting is performed using at least one of gases selected from an inert gas, an oxygen gas, and a mixed gas of an inert gas and an oxygen gas. The inert gas can be argon.

When the inorganic multilayer film 3 is formed in this manner, the water-and-oil repellent film 12 is formed on the inorganic multilayer film 3.

Examples of the method of forming the water-and-oil repellent film 12 include wet methods such as a dipping method, a spin-coating method and a spray method, and dry methods such as a vacuum deposition method.

Generally, a dipping method is frequently used from among the wet methods. This method is a method in which an optical component with layers up to the inorganic multilayer film 3 formed thereon is dipped in a liquid in which a fluorine-substituted alkyl group-containing organosilicon compound is dissolved in an organic solvent, and is lifted under a predetermined condition to be dried to thereby form a film.

As the organic solvent, perfluorohexane, perfluoro-4-methoxybutane, perfluoro-4-ethoxybutane, m-xylene hexafluoride, or the like is used.

The dilute concentration achieved using the organic solvent can be 0.01 wt % to 0.5 wt %, and is preferably 0.03 wt % to 0.1 wt %. When the concentration is too low, the water-and-oil repellent film 12 having a sufficient film thickness may not be obtained. In addition, when the concentration is too high, uneven coating may easily occur and material costs may also increase.

A vacuum deposition method is frequently used from among dry methods. This method is a method in which a fluorine-substituted alkyl group-containing organosilicon compound is heated and evaporated in a vacuum chamber to form the water-and-oil repellent film 12.

In the optical component 1 formed in this manner, the inorganic multilayer film 3 disposed on at least a surface having a greater curvature, of the front surface 2a of the plastic base 2 and the rear surface 2b of the plastic base 2, is designed to have a maximum reflectivity of 3% to 50% in a wavelength range of 380 nm to 780 nm, and thus excellent performance regarding both reflection characteristics and visibility can be secured as described above.

In addition, in the method of manufacturing the optical component, such an excellent optical component with good balance can be securely provided.

### EXAMPLES

Hereinafter, examples of the embodiments of the present invention will be described in more detail, but the present invention is not limited to the following examples.

### «Test 1»

On a urethane-based synthetic resin substrate, a silicon-based hard coating having a refractive index of 1.67 and a primer coating having a refractive index of 1.67 were prepared by thermal curing, and film formation was performed by a vacuum deposition method as follows.

Note that, as a urethane-based synthetic resin substrate, a substrate having a diopter in a range of -1.00D to -6.00D, having a curvature radius of the front surface in a range of 200 mm to 1300 mm, and having a curvature radius of the rear surface in a range of 100 mm to 170 mm was used.

As described above, since the diopter of the urethane-based synthetic resin substrate was negative, the curvature radius of the rear surface was smaller than the curvature radius of the front surface, and the curvature of the rear surface was greater than the curvature of the front surface, in each substrate.

### <Example 1>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³; Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.155λ, a second layer SiO₂ (refractive index: 1.47) having an optical film thickness of 0.045λ, a third layer ZrO₂ (refractive index: 2.00) having an optical film thickness of 0.485λ, and a fourth layer SiO₂ (refractive index: 1.47) having an optical film thickness of 0.335λ were sequentially applied from the plastic base side. λ as a center wavelength of design was 500 nm.

Front Surface: Using the same apparatus, in the same processing atmosphere, and after the same pretreatment as in the case of the rear surface, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ,, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

### <Comparative Example 1>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ,, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

Front Surface: Using the same apparatus, in the same processing atmosphere, and after the same pretreatment as in the case of the rear surface, a first layer ZrO₂ (refractive index: 2.00) having an optical film thickness of 0.155λ, a second layer SiO₂ (refractive index: 1.47) having an optical film thickness of 0.045λ, a third layer ZrO₂ (refractive index: 2.00) having an optical film thickness of 0.485λ, and a fourth layer SiO₂ (refractive index: 1.47) having an optical film thickness of 0.335λ were sequentially applied from the plastic base side. λ as a center wavelength of design was 500 nm.

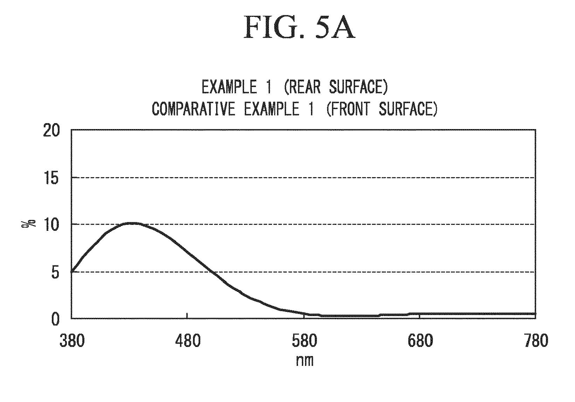

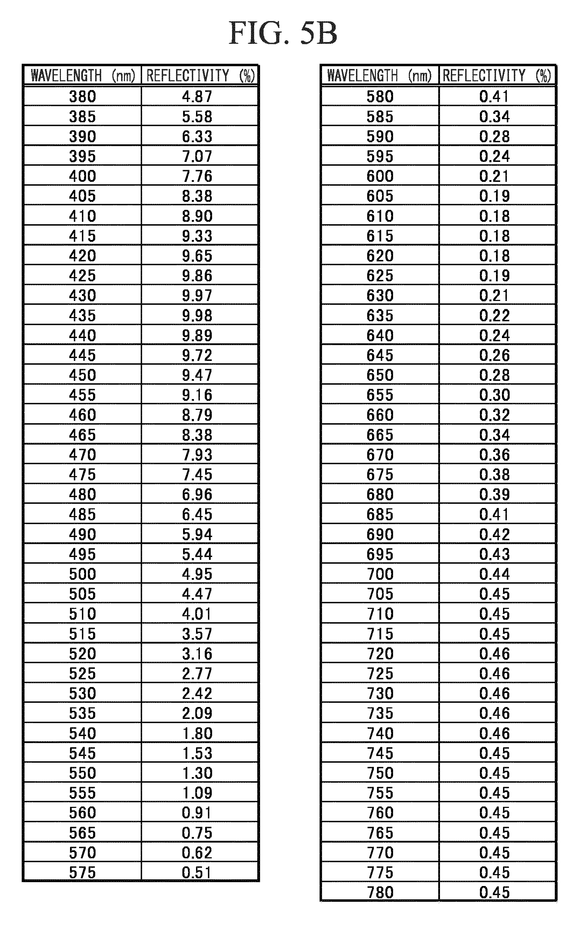

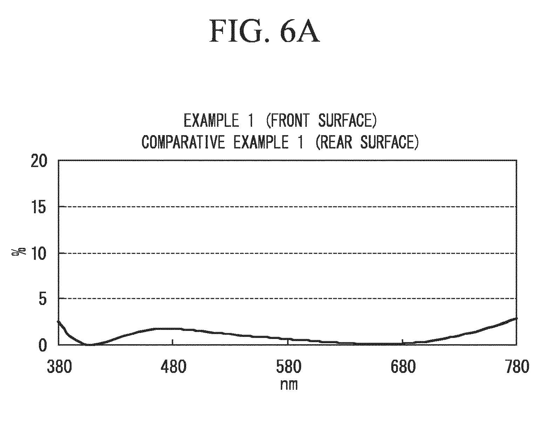

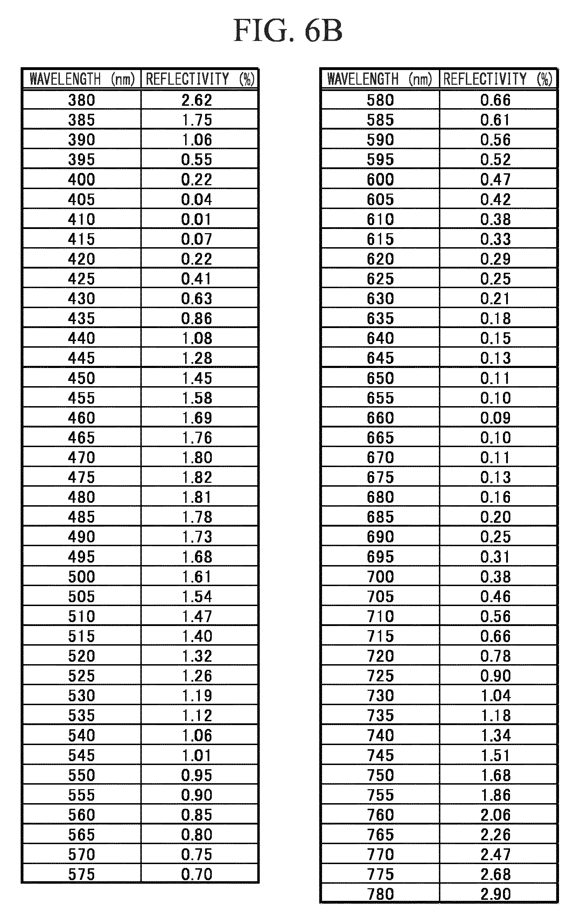

A graph of a spectral characteristic in a lens rear surface of Example 1 and a lens front surface of Comparative Example 1 is shown in FIG. 5A, and data of the spectral characteristic is shown in FIG. 5B. A graph of a spectral characteristic in a lens front surface of Example 1 and a lens rear surface of Comparative Example 1 is shown in FIG. 6A, and data of the spectral characteristic is shown in FIG. 6B.

### <Example 2>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.10λ, a second layer SiO₂ (refractive index: 1.47) having an optical film thickness of 0.505λ, a third layer ZrO₂ (refractive index: 2.00) having an optical film thickness of 0.215λ, a fourth layer SiO₂ (refractive index: 1.47) having an optical film thickness of 0.065λ, a fifth layer ZrO₂ (refractive index: 2.00) having an optical film thickness of 0.235λ, and a sixth layer SiO₂ (refractive index: 1.47) having an optical film thickness of 0.240λ were sequentially applied from the plastic base side. λ as a center wavelength of design was 500 nm.

Front Surface: Using the same apparatus, in the same processing atmosphere, and after the same pretreatment as in the case of the rear surface, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ,, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

### <Comparative Example 2>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ,, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

Front Surface: Using the same apparatus, in the same processing atmosphere, and after the same pretreatment as in the case of the rear surface, a first layer ZrO₂ (refractive index: 2.00) having an optical film thickness of 0.10λ, a second layer SiO₂ (refractive index: 1.47) having an optical film thickness of 0.505λ, a third layer ZrO₂ (refractive index: 2.00) having an optical film thickness of 0.215λ, a fourth layer SiO₂ (refractive index: 1.47) having an optical film thickness of 0.065λ, a fifth layer ZrO₂ (refractive index: 2.00) having an optical film thickness of 0.235λ, and a sixth layer SiO₂ (refractive index: 1.47) having an optical film thickness of 0.240λ were sequentially applied from the plastic base side. λ as a center wavelength of design was 500 nm.

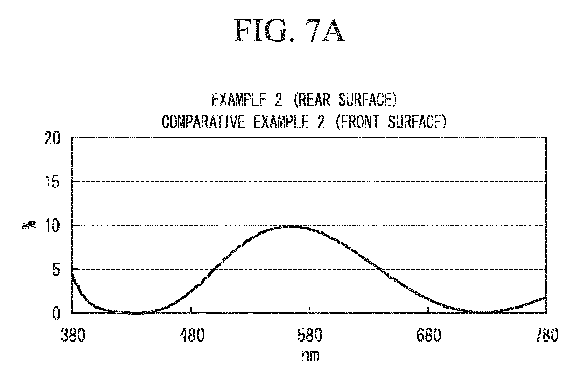

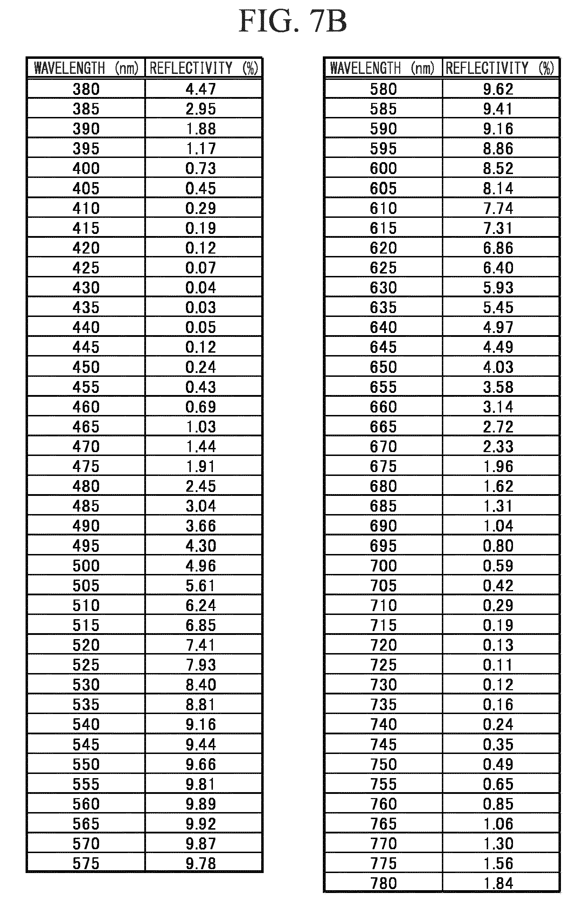

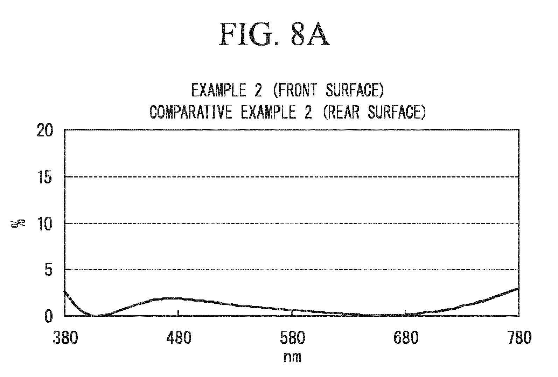

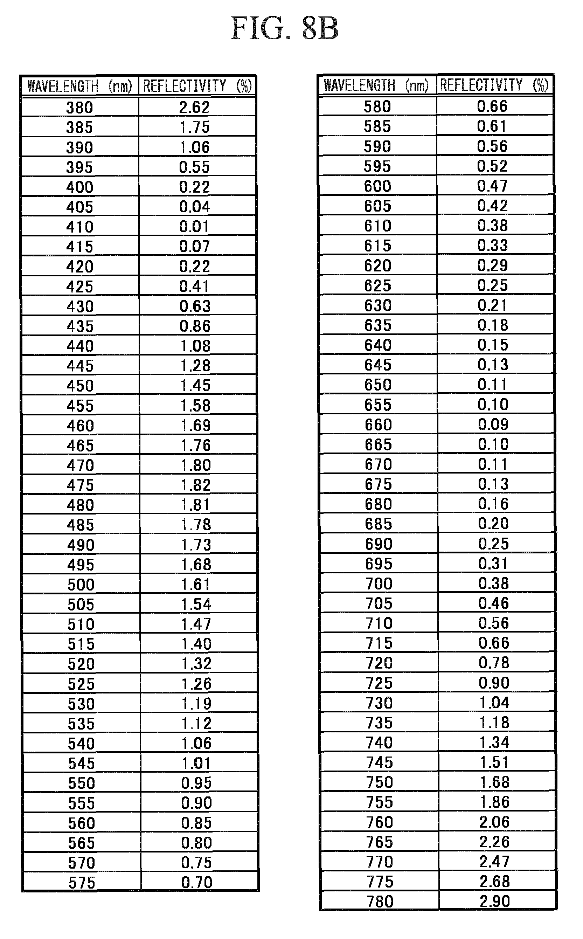

A graph of a spectral characteristic in a lens rear surface of Example 2 and a lens front surface of Comparative Example 2 is shown in FIG. 7A, and data of the spectral characteristic is shown in FIG. 7B. A graph of a spectral characteristic in a lens front surface of Example 2 and a lens rear surface of Comparative Example 2 is shown in FIG. 8A, and data of the spectral characteristic is shown in FIG. 8B.

### <Example 3>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0× 10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.125λ, a second layer SiO₂ (refractive index: 1.47) having an optical film thickness of 0.055λ, a third layer ZrO₂ (refractive index: 2.00) having an optical film thickness of 0.305λ, a fourth layer SiO₂ (refractive index: 1.47) having an optical film thickness of 0.535λ, a fifth layer ZrO₂ (refractive index: 2.00) having an optical film thickness of 0.265λ, a sixth layer SiO₂ (refractive index: 1.47) having an optical film thickness of 0.085λ, a seventh layer ZrO₂ (refractive index: 2.00) having an optical film thickness of 0.185λ, and an eighth layer SiO₂ (refractive index: 1.47) having an optical film thickness of 0.335λ were sequentially applied from the plastic base side. λ as a center wavelength of design was 500 nm.

Front Surface: Using the same apparatus, in the same processing atmosphere, and after the same pretreatment as in the case of the rear surface, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ,, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

### <Comparative Example 3>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.035λ, a second layer SiO₂ (refractive index: 1.47) having an optical film thickness of 0.135λ, a third layer ZrO₂ (refractive index: 2.00) having an optical film thickness of 0.04λ, a fourth layer SiO₂ (refractive index: 1.47) having an optical film thickness of 0.500λ, a fifth layer ZrO₂ (refractive index: 2.00) having an optical film thickness of 0.150λ, a sixth layer SiO₂ (refractive index: 1.47) having an optical film thickness of 0.06λ, a seventh layer ZrO₂ (refractive index: 2.00) having an optical film thickness of 0.225λ, and an eighth layer SiO₂ (refractive index: 1.47) having an optical film thickness of 0.280λ were sequentially applied from the plastic base side. λ as a center wavelength of design was 485 nm.

Front Surface: Using the same apparatus, in the same processing atmosphere, and after the same pretreatment as in the case of the rear surface, a first layer ZrO₂ (refractive index: 2.00) having an optical film thickness of 0.125λ, a second layer SiO₂ (refractive index: 1.47) having an optical film thickness of 0.055λ, a third layer ZrO₂ (refractive index: 2.00) having an optical film thickness of 0.305λ, a fourth layer SiO₂ (refractive index: 1.47) having an optical film thickness of 0.535λ, a fifth layer ZrO₂ (refractive index: 2.00) having an optical film thickness of 0.265λ, a sixth layer SiO₂ (refractive index: 1.47) having an optical film thickness of 0.085λ, a seventh layer ZrO₂ (refractive index: 2.00) having an optical film thickness of 0.185λ, and an eighth layer SiO₂ (refractive index: 1.47) having an optical film thickness of 0.335λ were sequentially applied from the plastic base side. λ as a center wavelength of design was 500 nm.

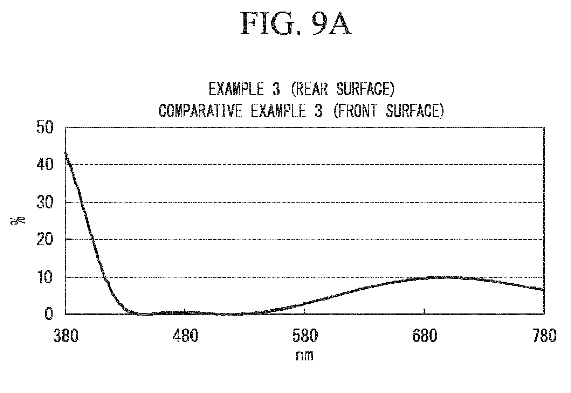

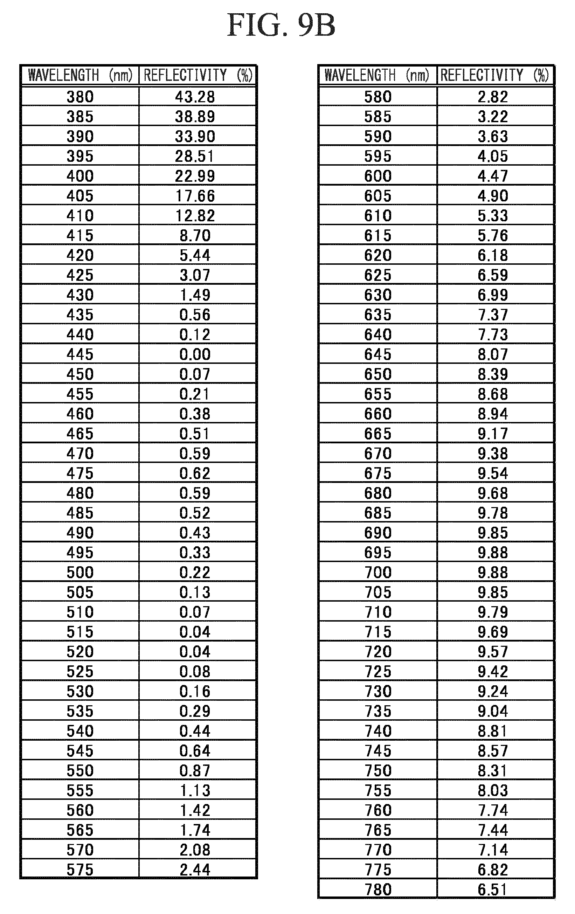

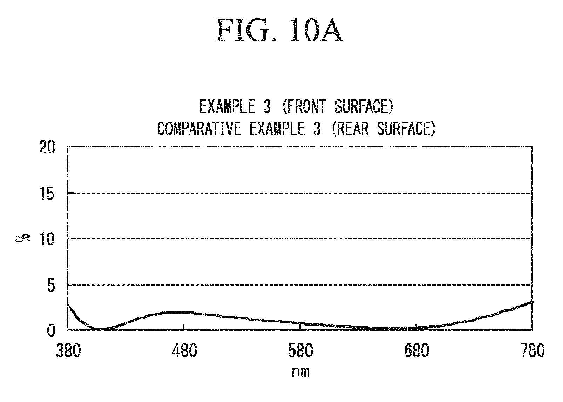

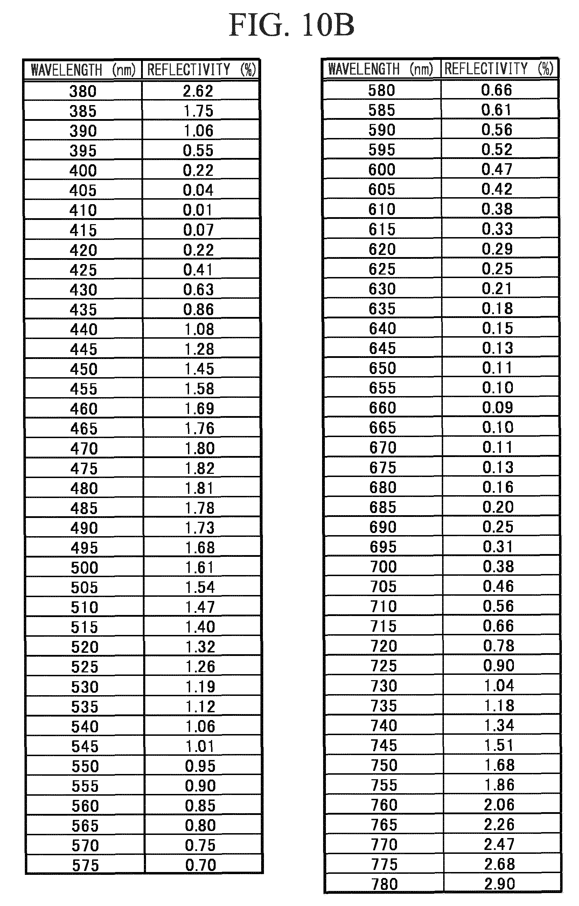

A graph of a spectral characteristic in a lens rear surface of Example 3 and a lens front surface of Comparative Example 3 is shown in FIG. 9A, and data of the spectral characteristic is shown in FIG. 9B. A graph of a spectral characteristic in a lens front surface of Example 3 and a lens rear surface of Comparative Example 3 is shown in FIG. 10A, and data of the spectral characteristic is shown in FIG. 10B.

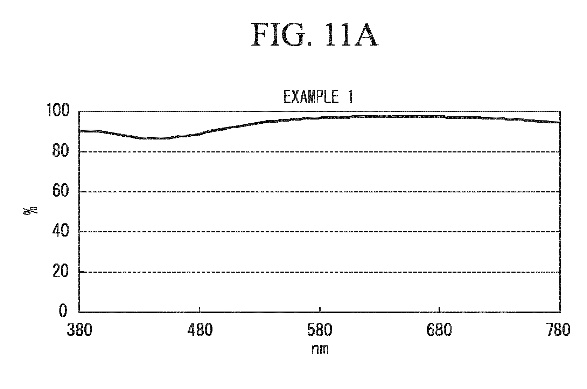

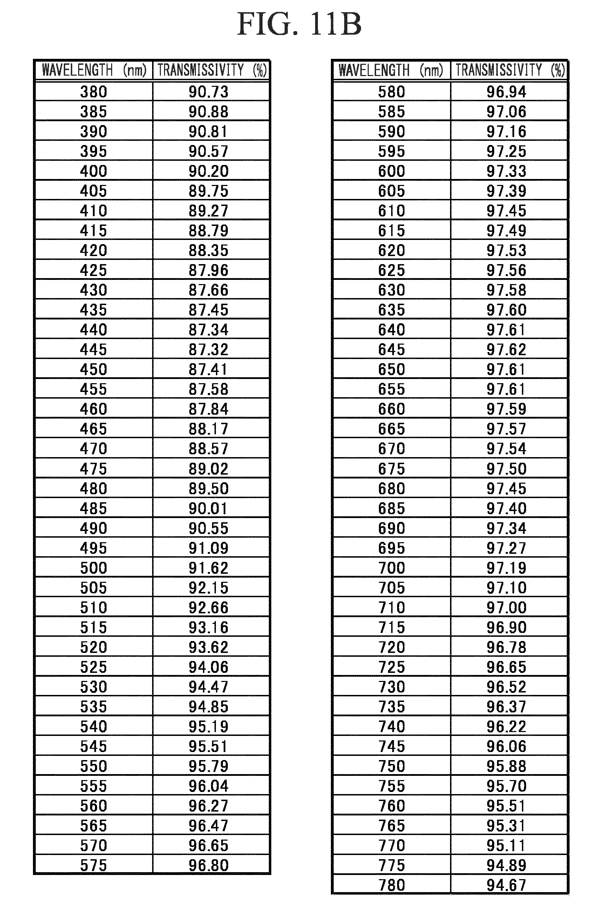

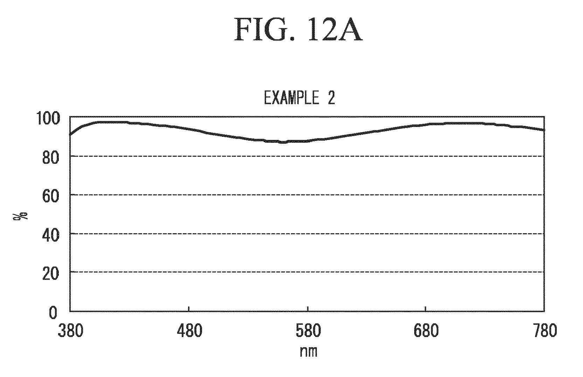

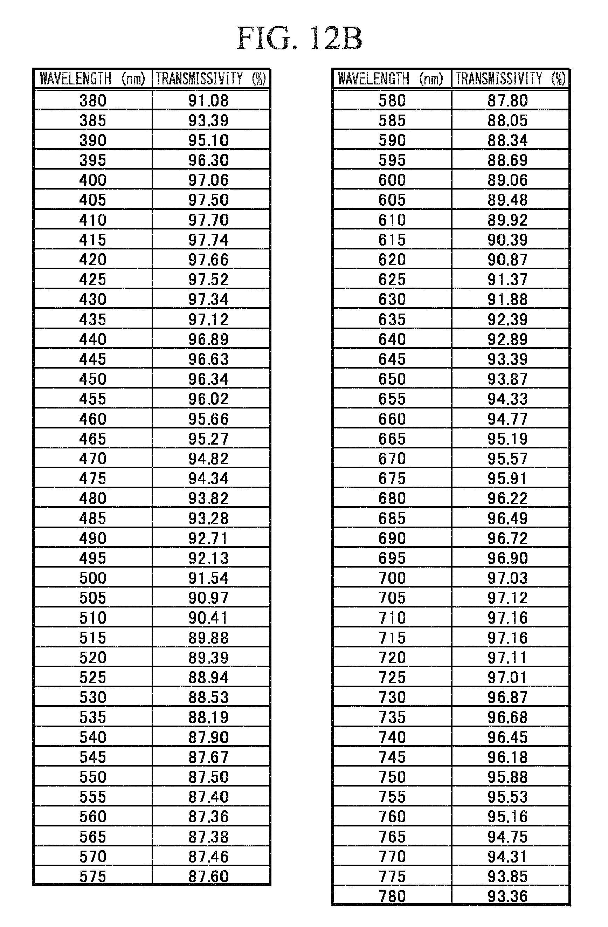

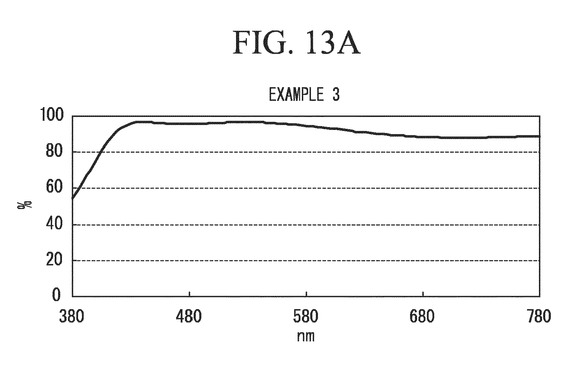

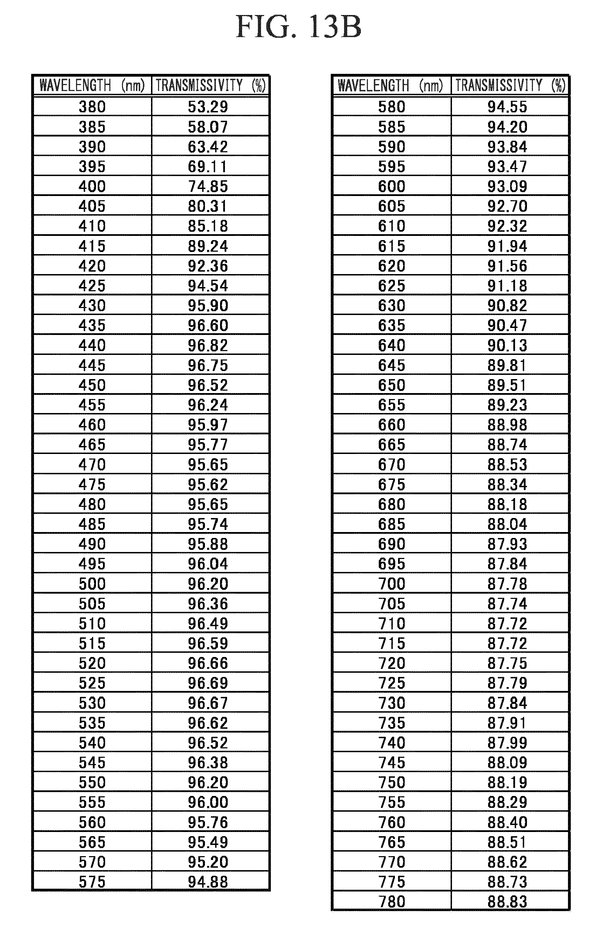

The formed layers in Examples 1 to 3 and Comparative Examples 1 to 3 are shown in detail in Table 1. In addition, transmission characteristic graphs in Examples 1 to 3 are shown in FIGS. 11A to 13A, and transmission characteristic data in Examples 1 to 3 are shown in FIGS. 11B to 13B.

**[Table 1A]**

| | <Example 1> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.155 *λ* | 39 | ZrO₂ | 0.035 *λ* | 8.5 |
| Second Layer | SiO₂ | 0.045 *λ* | 15 | SiO₂ | 0.135 *λ* | 45 |
| Third Layer | ZrO₂ | 0.485 *λ* | 122 | ZrO₂ | 0.04 *λ* | 9.8 |
| Fourth Layer | SiO₂ | 0.335 *λ* | 114 | SiO₂ | 0.500 *λ* | 165 |
| fifth Layer | | | | ZrO₂ | 0.150 *λ* | 37 |
| Sixth Layer | | | | SiO₂ | 0.06 *λ* | 20 |
| Seventh Layer | | | | ZrO₂ | 0.225 *λ* | 55 |
| Eighth Layer | | | | SiO₂ | 0.280 *λ* | 93 |
| | Maximum Reflectivity in 380 to 780 nm | | 10 | Maximum Reflectivity in 380 to 780 nm | | 2.9 |

| | <Comparative Example 1> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.035 *λ* | 8.5 | ZrO₂ | 0.155 *λ* | 39 |
| Second Layer | SiO₂ | 0.135 *λ* | 45 | SiO₂ | 0.045 *λ* | 15 |
| Third Layer | ZrO₂ | 0.04 *λ* | 9.8 | ZrO₂ | 0.485 *λ* | 122 |
| Fourth Layer | SiO₂ | 0.500 *λ* | 165 | SiO₂ | 0.335 *λ* | 114 |
| Fifth Layer | ZrO₂ | 0.150 *λ* | 37 | | | |
| Sixth Layer | SiO₂ | 0.06 *λ* | 20 | | | |
| Seventh Layer | ZrO₂ | 0.225 *λ* | 55 | | | |
| Eighth Layer | SiO₂ | 0.280 *λ* | 93 | | | |
| | Maximum Reflectivity in 380 to 780 nm | | 2.90 | Maximum Reflectivity in 380 to 780 nm | | 10 |

**[Table 1B]**

| | <Example 2> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.10 *λ* | 25 | ZrO₂ | 0.035 *λ* | 8.5 |
| Second Layer | SiO₂ | 0.505 *λ* | 170 | SiO₂ | 0.135 *λ* | 45 |
| Third Layer | ZrO₂ | 0.215 *λ* | 54 | ZrO₂ | 0.04 *λ* | 9.8 |
| Fourth Layer | SiO₂ | 0.065 *λ* | 22 | SiO₂ | 0.500 *λ* | 165 |
| Fifth Layer | ZrO₂ | 0.235 *λ* | 59 | ZrO₂ | 0.150 *λ* | 37 |
| Sixth Layer | SiO₂ | 0.240 *λ* | 82 | SiO₂ | 0.06 *λ* | 20 |
| Seventh Layer | | | | ZrO₂ | 0.225 *λ* | 55 |
| Eighth Layer | | | | SiO₂ | 0.280 *λ* | 93 |
| | Maximum Reflectivity in 380 to 780 nm | | 10 | Maximum Reflectivity in 380 to 780 nm | | 2.9 |

| | <Comparative Example 2> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.035 *λ* | 8.5 | ZrO₂ | 0.10 *λ* | 25 |
| Second Layer | SiO₂ | 0.135 *λ* | 45 | SiO₂ | 0.505 *λ* | 170 |
| Third Layer | ZrO₂ | 0.04 *λ* | 9.8 | ZrO₂ | 0.215 *λ* | 54 |
| Fourth Layer | SiO₂ | 0.500 *λ* | 165 | SiO₂ | 0.065 *λ* | 22 |
| Fifth Layer | ZrO₂ | 0.150 *λ* | 37 | ZrO₂ | 0.235 *λ* | 59 |
| Sixth Layer | SiO₂ | 0.06 *λ* | 20 | SiO₂ | 0.240 *λ* | 82 |
| Seventh Layer | ZrO₂ | 0.225 *λ* | 55 | | | |
| Eighth Layer | SiO₂ | 0.280 *λ* | 93 | | | |
| | Maximum Reflectivity in 380 to 780 nm | | 2.9 | Maximum Reflectivity in 380 to 780 nm | | 10 |

**[Table 1C]**

| | <Example 3> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.125 *λ* | 31 | ZrO₂ | 0.035 *λ* | 8.5 |
| Second Layer | SiO₂ | 0.055 *λ* | 19 | SiO₂ | 0.135 *λ* | 45 |
| Third Layer | ZrO₂ | 0.305 *λ* | 77 | ZrO₂ | 0.04 *λ* | 9.8 |
| Fourth Layer | SiO₂ | 0.535 *λ* | 183 | SiO₂ | 0.500 *λ* | 165 |
| Fifth Layer | ZrO₂ | 0.265 *λ* | 67 | ZrO₂ | 0.150 *λ* | 37 |
| Sixth Layer | SiO₂ | 0.085 *λ* | 29 | SiO₂ | 0.06 *λ* | 20 |
| Seventh Layer | ZrO₂ | 0.185 *λ* | 46 | ZrO₂ | 0.225 *λ* | 55 |
| Eighth Layer | Si02 | 0.335 *λ* | 114 | SiO₂ | 0.280 *λ* | 93 |
| | Maximum Reflectivity in 380 to 780 nm | | 43 | Maximum Reflectivity in 380 to 780 nm | | 2.9 |

| | <Comparative Example 3> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.035 *λ* | 8.5 | ZrO₂ | 0.125 *λ* | 31 |
| Second Layer | SiO₂ | 0.135 *λ* | 45 | SiO₂ | 0.055 *λ* | 19 |
| Third Layer | ZrO₂ | 0.04 *λ* | 9.8 | ZrO₂ | 0.305 *λ* | 77 |
| Fourth Layer | SiO₂ | 0.500 *λ* | 165 | SiO₂ | 0.535 *λ* | 183 |
| Fifth Layer | ZrO₂ | 0.150 *λ* | 37 | ZrO₂ | 0.265 *λ* | 67 |
| Sixth Layer | SiO₂ | 0.06 *λ* | 20 | SiO₂ | 0.085 *λ* | 29 |
| Seventh Layer | ZrO₂ | 0.225 *λ* | 55 | ZrO₂ | 0.185 *λ* | 46 |
| Eighth Layer | SiO₂ | 0.280 *λ* | 93 | SiO₂ | 0.335 *λ* | 114 |
| | Maximum Reflectivity in 380 to 780 nm | | 2.9 | Maximum Reflectivity in 380 to 780 nm | | 43 |

The wearing evaluation of the optical products obtained in this manner was performed.

### (Wearing Evaluation 1: confirmation of visibility and feeling of fatigue)

Glasses with the optical component manufactured in accordance with Example 1 were worn during PC deskwork to perform comparative evaluation with glasses with the optical component manufactured in accordance with Comparative Example 1.

Conditions in the evaluation and determination items are as follows.
The number of Monitors: 12
Display: 17-Inch Liquid Crystal Display
Working Time: 1 Hour/Day
Wearing Period: 1 Week
Determination Items: 1. Ease of Viewing Displayed Letters and the like, 2. Feeling of Fatigue
Determination Criteria: 1. Example is better, 2. Equivalent, 3. Comparative Example is better

The number of people answering each determination criterion is counted, and the results of Wearing Evaluation 1 are shown in Table 2.

**[Table 2]**

| <Results of Wearing Evaluation 1> | | | | | | |
|---|---|---|---|---|---|---|
| | Comparison between Example 1 and Comparative Example 1 | | | | | |
| Evaluation Item | (1) Ease of Viewing Displayed Letters and the like | | | (2) Feeling of Fatigue | | |
| Monitor No. | Example 1 is better | Equivalent | Comparative Example 1 is better | Example 1 is better | Equivalent | Comparative Example 1 is better |
| 1 | | ○ | | ○ | | |
| 2 | | ○ | | ○ | | |
| 3 | | ○ | | | ○ | |
| 4 | ○ | | | ○ | | |
| 5 | | ○ | | | ○ | |
| 6 | | ○ | | | ○ | |
| 7 | | ○ | | | ○ | |
| 8 | | ○ | | | ○ | |
| 9 | | ○ | | | ○ | |
| 10 | | ○ | | | ○ | |
| 11 | | ○ | | | ○ | |
| 12 | | ○ | | | ○ | |
| Total | 1 | 11 | 0 | 3 | 9 | 0 |

### (Wearing Evaluation 2: comparison of feeling of wearing such as annoyance due to incident light)

Glasses with the optical components manufactured in accordance with Examples 1 to 3 and Comparative Examples 1 to 3 were worn to perform comparative evaluation of the influence of incident light under various environments. Conditions in the evaluation and determination items are as follows.
The number of Monitors: 12
Evaluation Environments: 1. Office, 2. Inside of Daytime Train, 3. Nighttime
Wearing Period: 1 Week
Determination Items: 1. Glare of Ceiling Lighting, 2. Glare of Outside Light, 3. Glare of Street Lighting
Determination Criteria: 1. Example is better, 2. Equivalent, 3. Comparative Example is better

The number of people answering each determination criterion is counted, and the results of Wearing Evaluation 2 are shown in Table 3.

**[Table 3]**

| <Results of Wearing Evaluation 2> | | | | | | | | | |
|---|---|---|---|---|---|---|---|---|---|
| | Comparison between Example 1 and Comparative Example 1 | | | | | | | | |
| Evaluation Item | (1) Glare of Ceiling Lighting | | | (2) Glare of Outside Light | | | (3) Glare of Street Lighting | | |
| Monitor No. | Example 1 is better | Equivalent | Comparative Example 1 is better | Example 1 is better | Equivalent | Comparative Example 1 is better | Example 1 is better | Equivalent | Comparative Example 1 is better |
| 1 | | | ○ | ○ | | | | | ○ |
| 2 | | | ○ | ○ | | | | ○ | |
| 3 | | ○ | | | ○ | | | ○ | |
| 4 | | ○ | | ○ | | | | ○ | |
| 5 | ○ | | | ○ | | | ○ | | |
| 6 | ○ | | | ○ | | | | ○ | |
| 7 | ○ | | | ○ | | | | ○ | |
| 8 | | ○ | | ○ | | | | ○ | |
| 9 | | ○ | | | ○ | | | ○ | |
| 10 | ○ | | | ○ | | | ○ | | |
| 11 | | ○ | | ○ | | | | ○ | |
| 12 | | ○ | | ○ | | | | | ○ |
| Total | 4 | 6 | 2 | 10 | 2 | 0 | 2 | 8 | 2 |
| | | | | | | | | | |

| | Comparison between Example 2 and Comparative Example 2 | | | | | | | | |
|---|---|---|---|---|---|---|---|---|---|
| Evaluation Item | (1) Glare of Ceiling Lighting | | | (2) Glare of Outside Light | | | (3) Glare of Street Lighting | | |
| Monitor No. | Example 2 is better | Equivalent | Comparative Example 2 is better | Example 2 is better | Equivalent | Comparative Example 2 is better | Example 2 is better | Equivalent | Comparative Example 2 is better |
| 1 | | ○ | | ○ | | | | ○ | |
| 2 | | ○ | | ○ | | | | ○ | |
| 3 | | ○ | | ○ | | | | ○ | |
| 4 | | ○ | | ○ | | | | ○ | |
| 5 | | | ○ | | ○ | | | | ○ |
| 6 | ○ | | | | ○ | | | ○ | |
| 7 | ○ | | | | ○ | | | ○ | |
| 8 | | ○ | | ○ | | | | ○ | |
| 9 | | ○ | | | ○ | | | ○ | |
| 10 | | ○ | | ○ | | | | ○ | |
| 11 | | ○ | | ○ | | | | ○ | |
| 12 | | ○ | | ○ | | | | ○ | |
| Total | 2 | 9 | 1 | 8 | 4 | 0 | 0 | 11 | 1 |
| | | | | | | | | | |

| | Comparison between Example 3 and Comparative Example 3 | | | | | | | | |
|---|---|---|---|---|---|---|---|---|---|
| Evaluation Item | (1) Glare of Ceiling Lighting | | | (2) Glare of Outside Light | | | (3) Glare of Street Lighting | | |
| Monitor No. | Example 3 is better | Equivalent | Comparative Example 3 is better | Example 3 is better | Equivalent | Comparative Example 3 is better | Example 3 is better | Equivalent | Comparative Example 3 is better |
| 1 | | ○ | | ○ | | | | ○ | |
| 2 | ○ | | | | ○ | | ○ | | |
| 3 | | ○ | | | | ○ | ○ | | |
| 4 | ○ | | | ○ | | | | ○ | |
| 5 | | ○ | | ○ | | | | | ○ |
| 6 | ○ | | | ○ | | | | ○ | |
| 7 | ○ | | | ○ | | | | ○ | |
| 8 | | ○ | | ○ | | | | ○ | |
| 9 | | ○ | | | ○ | | | ○ | |
| 10 | | ○ | | ○ | | | | ○ | |
| 11 | | ○ | | ○ | | | | ○ | |
| 12 | | ○ | | ○ | | | | ○ | |
| Total | 4 | 8 | 0 | 9 | 2 | 1 | 2 | 9 | 1 |

As a result of such comparative wearing evaluation, it was confirmed that there was no difference with respect to visibility and feeling of fatigue between Example 1 and Comparative Example 1.

Regarding annoyance due to incident light, since many people answered that Example 1, Example 2, and Example 3 were better in annoyance due to glare of outside light, it was confirmed that by disposing a multilayer film having a maximum reflectivity of 3% to 50% in a wavelength range of 380 nm to 780 nm on the rear surface (face side surface), no annoyance due to incident light occurred and visibility was improved.

### «Test 2»

On a synthetic resin substrate, a silicon-based hard coating having a refractive index of 1.67 was prepared by thermal curing, and film formation was performed by a vacuum deposition method as follows.

Note that, as a urethane-based synthetic resin substrate, as in the case of Test 1, a substrate having a diopter in a range of -1.00D to -6.00D, having a curvature radius of the front surface in a range of 200 mm to 1300 mm, and having a curvature radius of the rear surface in a range of 100 mm to 170 mm was used. Since the diopter of the urethane-based synthetic resin substrate was negative, the curvature radius of the rear surface in each substrate was smaller than the curvature radius of the front surface, and the curvature of the rear surface was greater than the curvature of the front surface.

### <Example 4>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0× 10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.135λ, a second layer SiO₂ (refractive index: 1.47) having an optical film thickness of 0.085λ, a third layer ZrO₂ (refractive index: 2.00) having an optical film thickness of 0.20λ, a fourth layer SiO₂ (refractive index: 1.47) having an optical film thickness of 0.055λ, a fifth layer ZrO₂ (refractive index: 2.00) having an optical film thickness of 0.19λ, and a sixth layer SiO₂ (refractive index: 1.47) having an optical film thickness of 0.35λ were sequentially applied from the plastic base side. λ as a center wavelength of design was 500 nm.

Front Surface: Using the same apparatus, in the same processing atmosphere, and after the same pretreatment as in the case of the rear surface, a first layer ZrO₂ (refractive index: 2.00) having an optical film thickness of 0.11λ, a second layer SiO₂ (refractive index: 1.47) having an optical film thickness of 0.09λ, a third layer ZrO₂ (refractive index: 2.00) having an optical film thickness of 0.22λ, a fourth layer SiO₂ (refractive index: 1.47) having an optical film thickness of 0.06λ, a fifth layer ZrO₂ (refractive index: 2.00) having an optical film thickness of 0.20λ, and a sixth layer SiO₂ (refractive index: 1.47) having an optical film thickness of 0.33λ were sequentially applied from the plastic base side. λ as a center wavelength of design was 500 nm.

### <Example 5>

Rear Surface (face side): A lens was set in a rotating dome provided in a vacuum chamber, the temperature in the vacuum chamber was adjusted to 70 degrees Celsius by heating, air was exhausted until the pressure was adjusted to 1.0×10⁻³ Pa, and Ar ion beam cleaning was carried out for 60 seconds under conditions of an acceleration voltage of 500 V and an acceleration current of 100 mA. Then, a first layer ZrO₂ (refractive index: 2.00) having an optical film thickness of 0.11λ, a second layer SiO₂ (refractive index: 1.47) having an optical film thickness of 0.09λ, a third layer ZrO₂ (refractive index: 2.00) having an optical film thickness of 0.22λ, a fourth layer SiO₂ (refractive index: 1.47) having an optical film thickness of 0.06λ, a fifth layer ZrO₂ (refractive index: 2.00) having an optical film thickness of 0.20λ, and a sixth layer SiO₂ (refractive index: 1.47) having an optical film thickness of 0.33λ were sequentially applied from the plastic base side. λ as a center wavelength of design was 500 nm.

Front Surface: Using the same apparatus, in the same processing atmosphere, and after the same pretreatment as in the case of the rear surface, a first layer ZrO₂ (refractive index: 2.00) having an optical film thickness of 0.135λ, a second layer SiO₂ (refractive index: 1.47) having an optical film thickness of 0.085λ, a third layer ZrO₂ (refractive index: 2.00) having an optical film thickness of 0.20λ, a fourth layer SiO₂ (refractive index: 1.47) having an optical film thickness of 0.055λ, a fifth layer ZrO₂ (refractive index: 2.00) having an optical film thickness of 0.19λ, and a sixth layer SiO₂ (refractive index: 1.47) having an optical film thickness of 0.35λ were sequentially applied from the plastic base side. λ as a center wavelength of design was 500 nm.

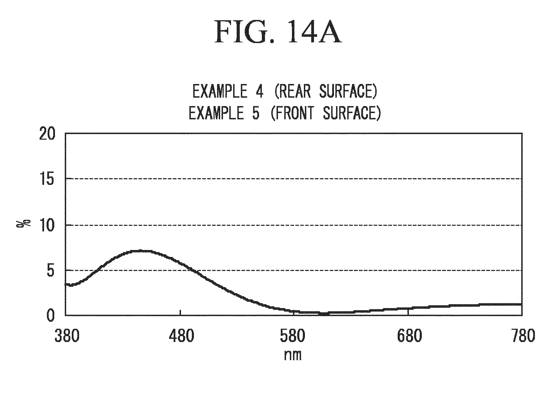

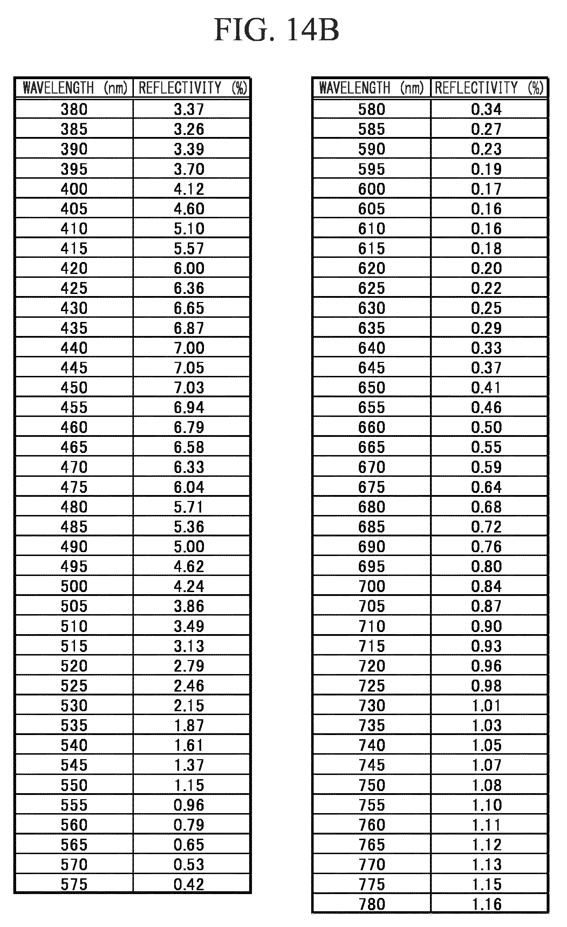

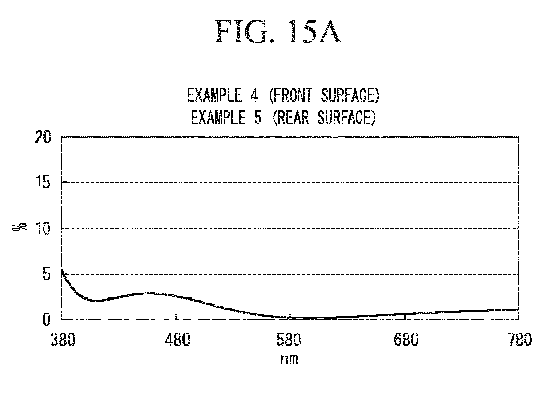

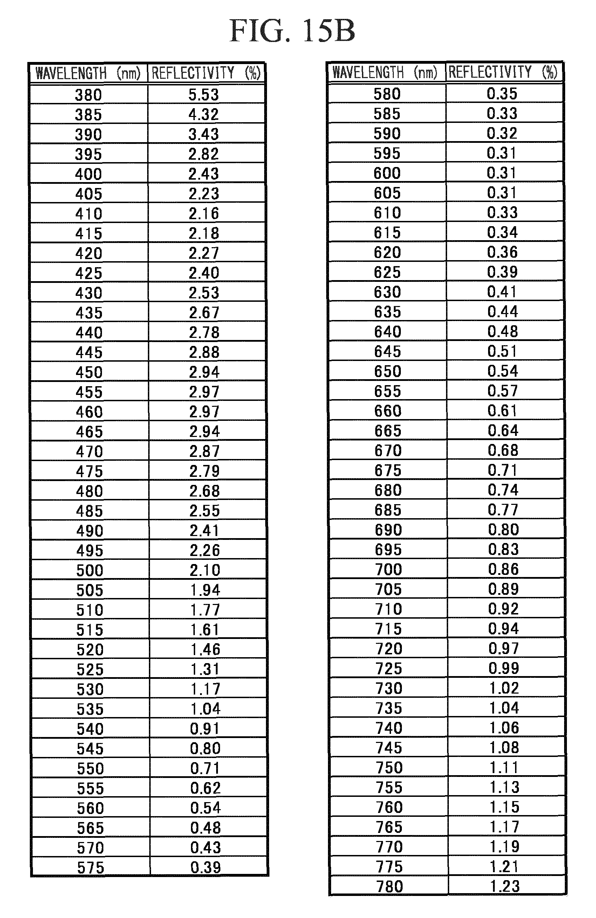

A graph of a spectral characteristic in a lens rear surface of Example 4 and a lens front surface of Example 5 is shown in FIG. 14A, and data of the spectral characteristic is shown in FIG. 14B. A graph of a spectral characteristic in a lens front surface of Example 4 and a lens rear surface of Example 5 is shown in FIG. 15A, and data of the spectral characteristic is shown in FIG. 15B.

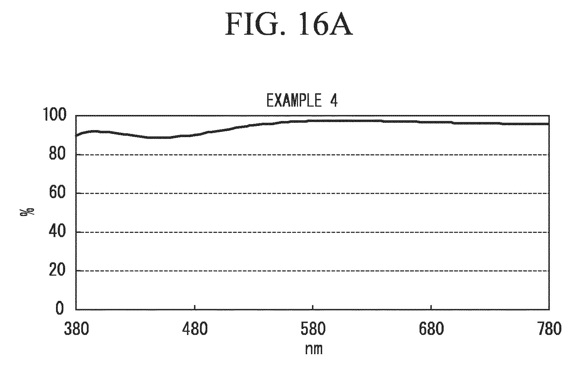

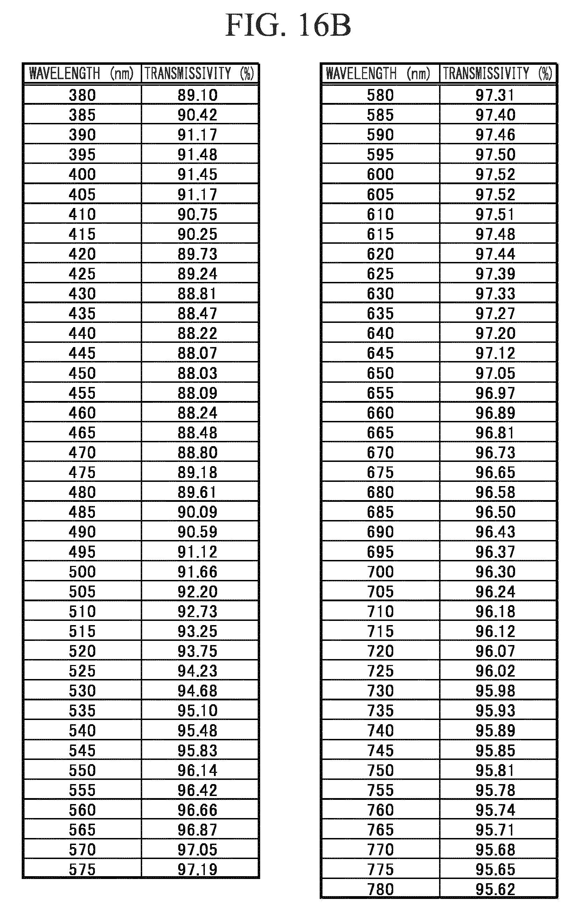

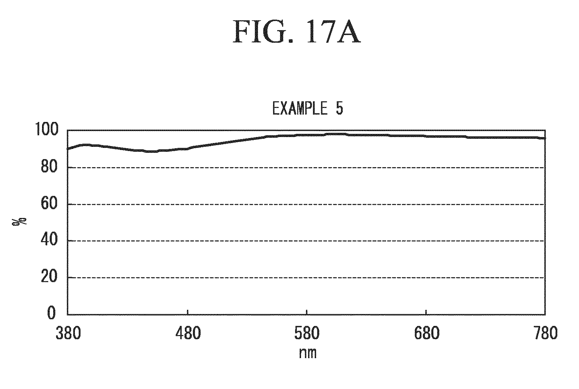

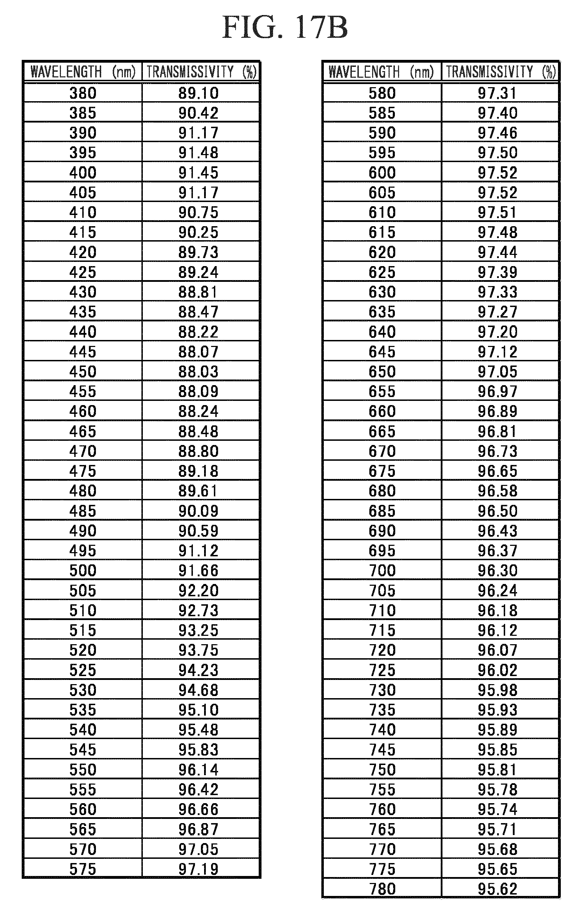

The formed layers in Example 4 and Example 5 are shown in detail in Table 4. In addition, transmission characteristic graphs in Example 4 and Example 5 are shown in FIGS. 16A to 17A, and transmission characteristic data in Example 4 and Example 5 are shown in FIGS. 16B to 17B.

**[Table 4]**

| | <Example 4> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.135 *λ* | 34 | ZrO₂ | 0.11 *λ* | 28 |
| Second Layer | Si02 | 0.085 *λ* | 29 | SiO₂ | 0.09 *λ* | 31 |
| Third Layer | ZrO₂ | 0.20 *λ* | 50 | ZrO₂ | 0.22 *λ* | 55 |
| Fourth Layer | Si02 | 0.055 *λ* | 19 | SiO₂ | 0.06 *λ* | 20 |
| Fifth Layer | ZrO₂ | 0.19 *λ* | 48 | ZrO₂ | 0.20 *λ* | 50 |
| Sixth Layer | SiO₂ | 0.35 *λ* | 119 | SiO₂ | 0.33 *λ* | 113 |
| | Maximum Reflectivity in 380 to 780 nm | | 7 | Maximum Reflectivity in 380 to 780 nm | | 5 |

| | <Example 5> | | | | | |
|---|---|---|---|---|---|---|
| | Rear Surface (Face Side) | | | Front Surface | | |
| | Material | Optical Film Thickness | Physical Film Thickness (nm) | Material | Optical Film Thickness | Physical Film Thickness (nm) |
| First Layer | ZrO₂ | 0.11 *λ* | 28 | ZrO₂ | 0.135 *λ* | 34 |
| Second Layer | Si02 | 0.09 *λ* | 31 | SiO₂ | 0.085 *λ* | 29 |
| Third Layer | ZrO₂ | 0.22 *λ* | 55 | ZrO₂ | 0.20 *λ* | 50 |
| Fourth Layer | Si02 | 0.06 *λ* | 20 | SiO₂ | 0.055 *λ* | 19 |
| Fifth Layer | ZrO₂ | 0.20 *λ* | 50 | ZrO₂ | 0.19 *λ* | 48 |
| Sixth Layer | Si02 | 0.33 *λ* | 113 | SiO₂ | 0.35 *λ* | 119 |
| | Maximum Reflectivity in 380 to 780 nm | | 5 | Maximum Reflectivity in 380 to 780 nm | | 7 |

The wearing evaluation of the optical products obtained in this manner was performed.

### (Wearing Evaluation 1: confirmation of visibility and feeling of fatigue)

Glasses with the optical component manufactured in accordance with Example 4 were worn during PC deskwork to perform comparative evaluation with glasses with the optical component manufactured in accordance with Example 5.

Conditions in the evaluation and determination items are as follows.
The number of Monitors: 12
Display: 17-Inch Liquid Crystal Display
Working Time: 1 Hour/Day
Wearing Period: 1 Week
Determination Items: 1. Ease of Viewing Displayed Letters and the like, 2. Feeling of Fatigue
Determination Criteria: 1. Example 4 is better, 2. Equivalent, 3. Example 5 is better

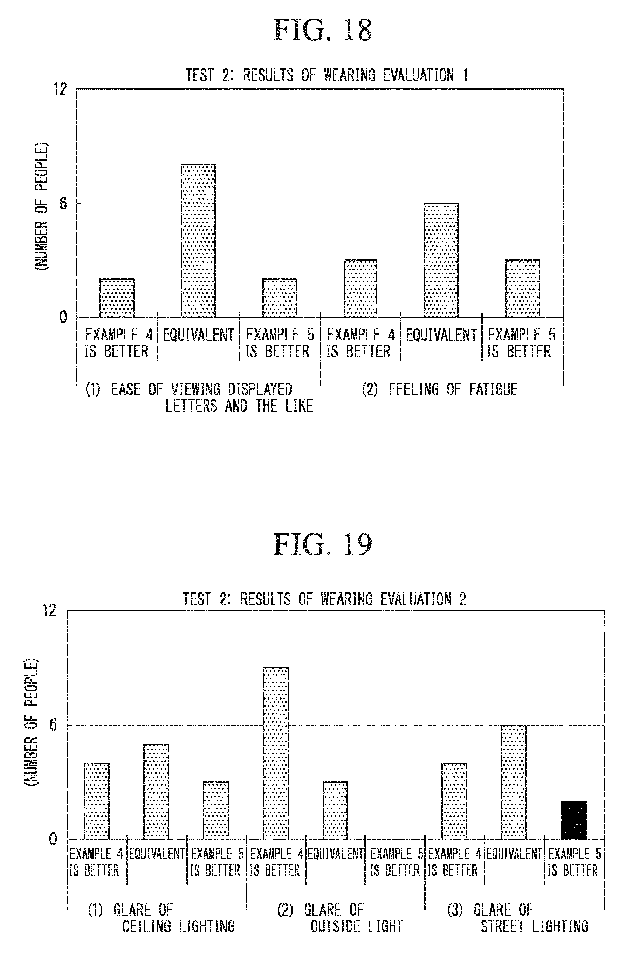

The number of people answering each determination criterion is counted, and the results of Wearing Evaluation 1 are shown in Table 5 and FIG. 18.

**[Table 5]**

| <Results of Wearing Evaluation 1> | | | | | | |
|---|---|---|---|---|---|---|
| Evaluation Item | (1) Ease of Viewing Displayed Letters and the like | | | (2) Feeling of Fatigue | | |
| Monitor No. | Example 4 is better | Equivalent | Example 5 is better | Example 4 is better | Equivalent | Example 5 is better |
| Total Number of People | 2 | 8 | 2 | 3 | 6 | 3 |

### (Wearing Evaluation 2: comparison of feeling of wearing such as annoyance due to incident light)

Glasses with the optical components manufactured in accordance with Example 4 and Example 5 were worn to perform comparative evaluation of the influence of incident light under various environments. Conditions in the evaluation and determination items are as follows.
The number of Monitors: 12
Evaluation Environments: 1. Office, 2. Inside of Daytime Train, 3. Nighttime
Wearing Period: 1 Week
Determination Items: 1. Glare of Ceiling Lighting, 2. Glare of Outside Light, 3. Glare of Street Lighting
Determination Criteria: 1. Example 4 is better, 2. Equivalent, 3. Example 5 is better

The number of people answering each determination criterion is counted, and the results of Wearing Evaluation 2 are shown in Table 6 and FIG. 19.

**[Table 6]**

| <Results of Wearing Evaluation 2> | | | | | | | | | |
|---|---|---|---|---|---|---|---|---|---|
| Evaluation Item | (1) Glare of Ceiling Lighting | | | (2) Glare of Outside Light | | | (3) Glare of Street Lighting | | |
| Monitor No. | Example 4 is better | Equivalent | Example 5 is better | Example 4 is better | Equivalent | Example 5 is better | Example 4 is better | Equivalent | Example 5 better |
| Total Number of People | 4 | 5 | 3 | 9 | 3 | 0 | 4 | 6 | 2 |

As a result of such comparative wearing evaluation, it was confirmed that there was no difference with respect to visibility and feeling of fatigue between Example 4 and Example 5. Regarding annoyance due to incident light, in both of Example 4 and Example 5, annoyance due to glare of outside light was at a level where no problem occurred, but when comparing both Examples, the number of people answering that Example 4 was better was more.

Thus, it was confirmed that by disposing a multilayer film having a maximum reflectivity of 3% to 50% in a wavelength range of 380 nm to 780 nm on the rear surface (face side) and setting a maximum reflectivity of the rear surface to be greater than the maximum reflectivity of the front surface, no annoyance due to incident light occurred and visibility was improved.

In addition, according to a simulation of focus of reflection light, when the intensity of light which is reflected by a lens rear surface having a curvature radius of 200 mm and focuses on the eye is set to be a reference, simulation results show that the intensity of light in case of a curvature radius of 250 mm is 1.3 times as much as the reference, the intensity of light in case of a curvature radius of 350 mm is 1.5 times as much as the reference, and the intensity of light in case of a curvature radius of 1300 mm is 1.7 times as much as the reference.

From also such numerical values, it is clear that in a lens having a negative diopter, by disposing, on the rear surface having a greater curvature, a multilayer film having a maximum reflectivity in a wavelength range of 380 nm to 780 nm which is greater than the maximum reflectivity of the front surface having a smaller curvature, no annoyance due to incident light occurs and visibility is improved.

From the above results, according to an aspect of the present invention, it is clear that an optical component which has a filter function such as an antiglare effect and excellent visibility without feeling of fatigue which is caused by wearing and a method of manufacturing the optical component can be provided.

### DESCRIPTION OF THE REFERENCE SYMBOLS

1, 1': OPTICAL COMPONENT
2: PLASTIC BASE
3, 3': INORGANIC MULTILAYER FILM
4: FUNCTIONAL THIN FILM
5: PRIMER LAYER (FUNCTIONAL THIN FILM)
6: HARD COATING LAYER (FUNCTIONAL THIN FILM)
7, 7': HIGH REFRACTIVE INDEX LAYER
8, 8': LOW REFRACTIVE INDEX LAYER
9, 9': FIRST LAYER
10, 10': SECOND LAYER
11, 11': THIRD LAYER
12: WATER-AND-OIL REPELLENT FILM
30: DEPOSITION APPARATUS
30': FILM FORMATION APPARATUS
31: FIRST FILM FORMATION CHAMBER
32: SECOND FILM FORMATION CHAMBER
33: THIRD FILM FORMATION CHAMBER
34: HOLDING MEMBER
35, 35': DEPOSITION SOURCE
35A: FIRST DEPOSITION SOURCE
35B: SECOND DEPOSITION SOURCE
36: LIGHT SOURCE DEVICE
37: ION GUN

## Claims

1. An optical component comprising:
a plastic base; and a multilayer film disposed on at least a surface having a greater curvature, of a front surface of the plastic base and a rear surface of the plastic base, wherein
the multilayer film has a maximum reflectivity of 3% to 50% in a wavelength range of 380 nm to 780 nm.

2. The optical component according to claim 1, wherein
a diopter of the plastic base is negative.

3. The optical component according to claim 1 or 2, wherein
the maximum reflectivity of the multilayer film disposed on the surface having a greater curvature is greater than the maximum reflectivity of a multilayer film disposed on a surface having a smaller curvature.

4. The optical component according to any one of claims 1 to 3, wherein
a difference between the maximum reflectivity of the multilayer film disposed on the surface having a greater curvature and the maximum reflectivity of the multilayer film disposed on the surface having a smaller curvature is 2% to 49%.

5. The optical component according to any one of claims 1 to 4, wherein
an antireflection film having an average reflectivity of 5.0% or less in a wavelength range of 380 nm to 780 nm is disposed on the surface having a smaller curvature.

6. The optical component according to any one of claims 1 to 5, wherein
the plastic base is colored, and a transmissivity of the plastic base is 5% to 85%.

7. The optical component according to any one of claims 1 to 6, further comprising:
a water-and-oil repellent film including a fluorine-substituted alkyl group-containing organosilicon compound on an outermost layer of the multilayer film which is the farthest from the plastic base.

8. The optical component according to claim 7, wherein
the fluorine-substituted alkyl group-containing organosilicon compound is one or more of fluorine-substituted alkyl group-containing organosilicon compounds selected from following general formulas (1) to (6): 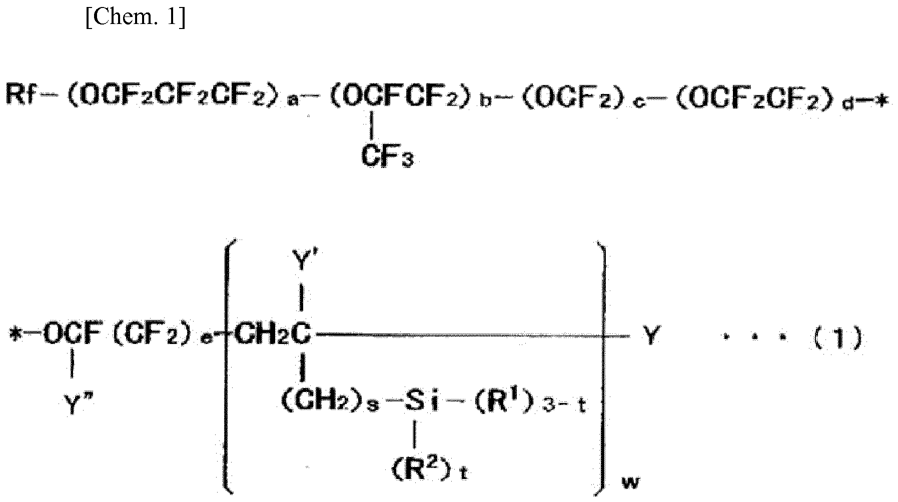 (in the formula (1), Rf represents a straight or branched perfluoroalkyl group with 1 to 16 carbon atoms, Y represents iodine or hydrogen, Y' represents hydrogen or a lower alkyl group with 1 to 5 carbon atoms, Y" represents fluorine or a trifluoromethyl group, R¹ represents a hydrolyzable group, R² represents hydrogen or an inert monovalent organic group, a, b, c, and d each represents an integer of 0 to 200, e represents 0 or 1, s and t each represents an integer of 0 to 2, and w represents an integer of 1 to 10); 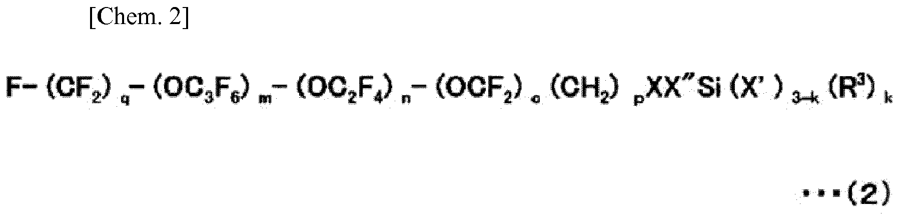 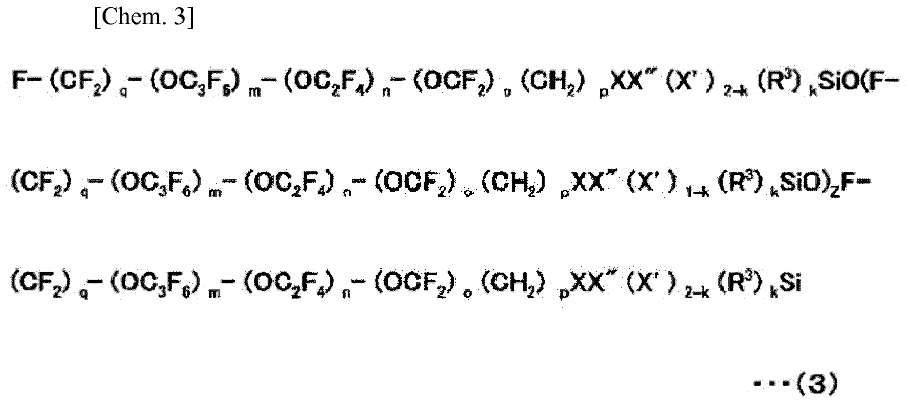 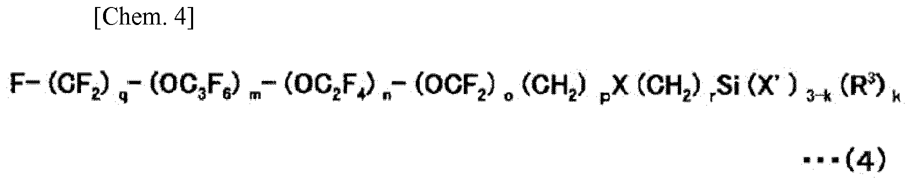 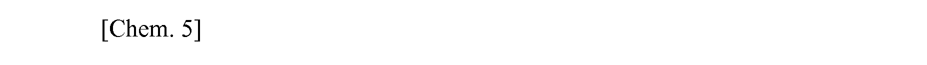 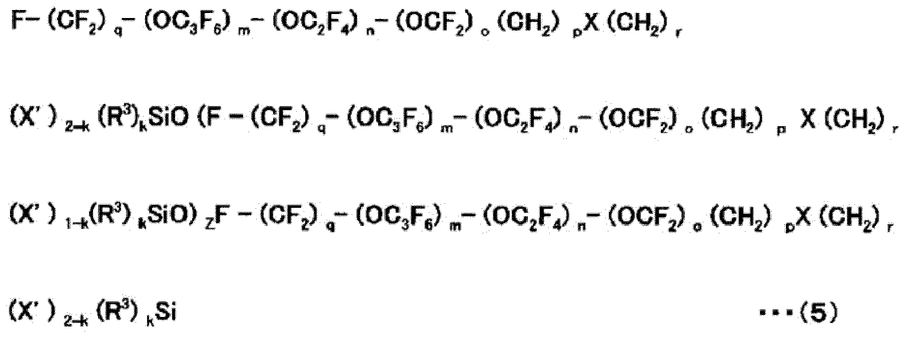 (in the formulas (2) to (5), X represents oxygen or a divalent organic group, X' represents a hydrolyzable group, X" represents a divalent organosilicon group, R³ represents a straight or branched alkylene group with 1 to 22 carbon atoms, q represents an integer of 1 to 3, m, n, and o each represents an integer of 0 to 200, p represents 1 or 2, r represents an integer of 2 to 20, k represents an integer of 0 to 2, and z represents an integer of 0 to 10 when k is 0 or 1); and 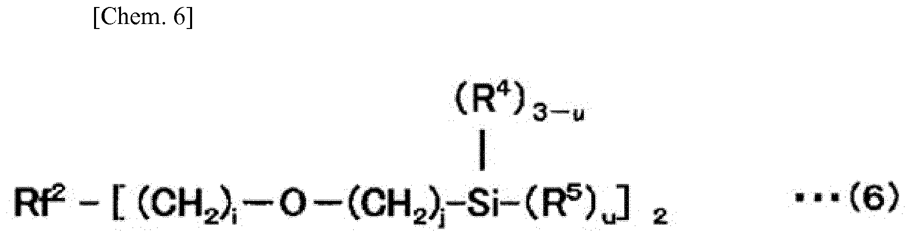 (in the formula (6), Rf² represents a divalent straight perfluoropolyether group, R⁴ represents a phenyl group or an alkyl group with 1 to 4 carbon atoms, R⁵ represents a hydrolyzable group, i represents an integer of 0 to 2, j represents an integer of 1 to 5, and u represents 2 or 3).

9. The optical component according to any one of claims 1 to 8, wherein
the multilayer film is a multilayer film having four or more layers.

10. The optical component according to any one of claims 1 to 9, wherein
a functional thin film is provided between the plastic base and the multilayer film.

11. The optical component according to any one of claims 1 to 10, wherein
a dielectric film or a metallic film having a thickness of 20 nm or less is provided between a high refractive index material and a low refractive index material, the materials constituting the multilayer film.

12. The optical component according to any one of claims 1 to 11, wherein
the high refractive index material includes zirconium dioxide, and the low refractive index material includes silicon dioxide.

13. The optical component according to any one of claims 1 to 12, the component being used for a spectacle lens.

14. A method of manufacturing an optical component according to any one of claims 1 to 13, the optical component being provided with a plastic base and a multilayer film disposed on at least a surface having a greater curvature, of a front surface of the plastic base and a rear surface of the plastic base, the method comprising:
a step of heating the plastic base; and a step of forming the multilayer film on the plastic base after adjusting a temperature of the plastic base to a predetermined temperature by the heating, wherein
the step of forming the multilayer film has a process of forming a high refractive index layer having a multilayer structure by alternately applying a high refractive index material and a low refractive index material in multilayers and has a process of forming, on the high refractive index layer, a low refractive index layer formed by a low refractive index material having a lower refractive index than a refractive index of the high refractive index layer, and wherein
a maximum reflectivity of the multilayer film in a wavelength range of 380 nm to 780 nm is 3% to 50%.

15. The method of manufacturing an optical component according to claim 14, comprising:
a step of forming the multilayer film by using a vacuum deposition method.

16. The method of manufacturing an optical component according to claim 14 or 15, wherein
the step of forming the multilayer film comprises a step of performing ion beam assisted film formation to form at least one layer of layers which constitute the multilayer film.

17. The method of manufacturing an optical component according to claim 16, wherein
the ion beam assisting is performed using at least one of gases selected from an inert gas, an oxygen gas, and a mixed gas of an inert gas and an oxygen gas.

18. The method of manufacturing an optical component according to claim 17, wherein
the inert gas is argon.

19. A spectacle lens comprising:
a plastic base having a front surface and a rear surface;
a first multilayer film provided on the front surface, the first multilayer film having an average reflectivity of 3% or less in a wavelength range of 380 nm to 780 nm; and
a second multilayer film provided on the rear surface, the second multilayer film having an average reflectivity of 2% to 13% in a 30-nm-width range including a first wavelength of a local maximum reflectivity, the range being in a wavelength range of 415 nm to 780 nm.

20. The spectacle lens according to claim 19, wherein
a difference between a reflectivity of the first multilayer film and a reflectivity of the second multilayer film at the first wavelength is 1% to 10%.

21. A spectacle lens comprising:
a plastic base having a front surface and a rear surface;
a first multilayer film provided on the front surface, the first multilayer film having an average reflectivity of less than 3% in a wavelength range of 380 nm to 780 nm; and
a second multilayer film provided on the rear surface, the second multilayer film having an average reflectivity of 3% to 30% in a 30-nm-width range including a first wavelength at which a reflectivity is maximized, the range being in a wavelength range of 380 nm to 500 nm.

22. The spectacle lens according to claim 21, wherein
a difference between a reflectivity of the first multilayer film and a reflectivity of the second multilayer film at the first wavelength is 3% to 41%.

23. The spectacle lens according to claim 21 or 22, wherein
the first multilayer film has an average reflectivity of less than 1.5% in a wavelength range of 380 nm to 780 nm and has an average reflectivity of less than 3% in a wavelength range of 380 nm to 500 nm.

24. The spectacle lens according to any one of claims 21 to 23, further comprising:
an antireflection film provided on the front surface and having an average reflectivity of 5.0% or less in a wavelength range of 380 nm to 780 nm.

25. The spectacle lens according to any one of claims 21 to 24, wherein
the plastic base is colored, and a transmissivity of the plastic base is 5% to 85%.

26. The spectacle lens according to any one of claims 21 to 25, further comprising:
a water-and-oil repellent film including a fluorine-substituted alkyl group-containing organosilicon compound on an outermost layer of the multilayer film which is the farthest from the plastic base.

27. A method of manufacturing a spectacle lens, the method comprising:
a step of heating a plastic base; and
a step of forming a multilayer film on the heated plastic base,
the step including: a process of forming a high refractive index layer of a multilayer structure having a layer of a high refractive index material and a layer of a low refractive index material; and a process of forming a low refractive index layer having a lower refractive index relative to the high refractive index layer, and wherein
a first multilayer film provided on a front surface has an average reflectivity of less than 3% in a wavelength range of 380 nm to 780 nm, and
a second multilayer film provided on a rear surface has an average reflectivity of 3% to 30% in a 30-nm-width range including a first wavelength at which a reflectivity is maximized, the range being in a wavelength range of 380 nm to 500 nm.
